# EUROPEAN PATENT APPLICATION

(11) **EP 4 842 181 A1**
(43) Date of publication of application: **18.11.2026**
(21) Application number: 25176609.3
(22) Date of filing: 15.05.2025
(51) Int. Cl.: H10K 85/30, H10K 30/50, H10K 50/155, H10K 50/17, H10K 10/46

(54) **CERIUM (IV) COMPLEXES WITH TWO LIGANDS AND THE USE THEREOF IN ORGANIC ELECTRONICS**

(71) Applicant: CREDOXYS GmbH, 01187 Dresden (DE)
(72) Inventor: EYMANN, Léonard, 01187 Dresden (DE); WOLTERING, Steffen, 01187 Dresden (DE); VOGEL, Till, 01187 Dresden (DE); PAPMEYER, Marcus, 01187 Dresden (DE); DOROK, Sascha, 01187 Dresden (DE)

(57) **Abstract**

The present invention relates to an electronic component and a doped semiconductor layer comprising cerium (IV) complexes of formula (I) as well as to a use of the cerium (IV) complexes of formula (I) as organic doping agent, as p-dopant in a hole transport layer, as a hole injector in a hole injection layer, or as hole injection layer itself. The invention also relates to semiconductor units comprising the compounds of formula (I) as well as to a method to produce such a doped semiconductor layer. The invention also relates to cerium (IV) complexes of formula (I).

## Description

The present invention relates to an electronic component and a doped semiconductor layer comprising cerium (IV) complexes of formula (I) as well as to a use of the cerium (IV) complexes of formula (I) as organic doping agent, as p-dopant in a hole transport layer, as a hole injector in a hole injection layer, or as hole injection layer itself. The invention also relates to semiconductor units comprising the compounds of formula (I) as well as to a method to produce such a doped semiconductor layer. The invention also relates to cerium (IV) complexes of formula (I).

### BACKGROUND OF THE INVENTION

Organic electronics focuses on the development, characterization and application of new materials, both based on small organic molecules and polymers with certain desired electronic properties for the production of electronic components.

These include, for example, organic field-effect transistors (OFETs), such as organic thin-film transistors (OTFTs), organic electroluminescent devices, such as organic light-emitting diodes (OLEDs), organic solar cells (OSCs), e.g. exciton solar cells, dye-sensitized solar cells (DSSCs), or perovskite solar cells; electrophotography, e.g., photoconductive materials in organic photoconductors (OPCs); organic optical detectors; organic photoreceptors; light-emitting electrochemical cells (LECs); and organic laser diodes.

It is known that organic semiconductor matrices can be strongly influenced in terms of their electrical conductivity by doping. Such organic semiconductor layers of semiconductor matrix material can be built either from compounds with electron donor properties (p-type conductors) or from compounds with electron acceptor properties (n-type conductors). Unlike inorganic semiconductors, organic semiconductors have very low intrinsic charge carrier density. To achieve good semiconductor properties, organic semiconductor matrix materials are therefore usually doped. For n-doping, strong electron donors (n-dopants) are used to transfer an electron to the LUMO (lowest unoccupied molecular orbital) of the semiconductor matrix (n-doping), resulting in a free electron on the matrix (SOMO - singly occupied molecular orbital). For p-doping, strong electron acceptors (p-dopants) are used to remove an electron from the HOMO (highest occupied molecular orbital) of the semiconductor matrix (p-doping), leaving a hole. In other words, for effective p-doping, the LUMO of the dopant must be similar or below the HOMO energy of the matrix. The p-dopant acts as an acceptor for an electron, leaving a moving hole (SOMO) in the matrix. Due to the requirement of such a deep LUMO of the p-dopant, only very few materials are suitable for an application as p-dopant.

Known p-dopants and/or hole injection materials for electron donor materials are electron acceptors such as tetracy-anoquione methane (TCNQ), 2,3,5,6-tetrafluorotetracyano-1,4-benzoquinone methane (F4TCNQ), trinaphthylenes (HATNA), metal oxides such as MoO₃ or WO₃, or radialene compounds as e.g. described in EP 2180029. The acceptor molecules generate so-called holes in the semiconductor matrix materials (hole transport materials) by electron transfer processes, and the conductivity of the semiconductor matrix material (hole transport material) is more or less changed depending on the number and mobility of the holes.

Known as a matrix material with hole transport properties are for example, N,N'-perarylated benzidines such as TPD or N,N',N"-perarylated starburst compounds such as the substance TDATA, or, however, also certain metal phthalocyanines, such as in particular zinc phthalocyanine ZnPc . Such kind of electron acceptor compounds are e.g. described in EP2180029 A1, which regards the use of radialene compounds as doping agents for an organic semiconductive matrix material.

However, the compounds or compound classes described above have disadvantages for technical use in the production of doped semiconductors or corresponding electronic components with such doped layers as they have too high absorption coefficients, are too volatile, exhibit an unstable evaporation rate, have a too low electron affinity and/or show low thermostability. A high absorption leads to an unwanted reduction of efficiency in light-emitting components (such as OLEDs) and light-converting components (such as solar cells). High volatility, unstable evaporation behaviour and low thermostability results in undesired irregularities in the performance of the electronic component and reduction of component stability. In addition, some of these substance classes have very high manufacturing costs.

Furthermore, there are new developments in the field of p-dopants, e.g. metal complexes are applied as p-dopants. A very promising class of p-dopants are based on Cerium (IV) complexes as described in EP 4029069 A1 or in EP 4305681A1. The continuous development of novel hole transport materials with unprecedented properties also requires the development of novel p-dopants with versatile doping properties.

Accordingly, there remains a need to improve semiconductor materials and of devices comprising these semiconductor materials and it is an object of the present invention to overcome the disadvantages of the state of the art, in particular to make new organic compounds available that can be used in particular as doping agent for the doping of organic semiconductors, that can furthermore be more readily handled in the production process and that result in electronic components whose organic semi-conductive materials can be reproducibly manufactured. Furthermore, the present invention is providing a versatile structure class that allows the design of electron acceptor compounds by tethering different types of substituents. In particular, hole transport materials with a wide range of HOMO-levels shall be dopable by the new organic mesomeric compounds.

This object is solved by the independent claims of the present application. Preferred embodiments are disclosed in the subclaims.

### SUMMARY OF THE INVENTION

A first object of the invention is an electronic component comprising at least one compound of the formula (I)

[Ce⁴⁺] L_{A}²⁻L_{B}²⁻ (I),

wherein L_{A}, L_{B} are independently of each other a tetradentate ligand with at least 26 carbon atoms,
wherein L_{A}, L_{B} are each coordinating with at least four Oxygen atoms to Ce⁴⁺, wherein L_{A}, L_{B} have the same or different meanings.

According to one embodiment, L_{A}, L_{B} are each coordinating with exactly four Oxygen atoms to Ce⁴⁺.

According to one embodiment, the electronic component is in the form of an organic light-emitting diode, a display device, a photovoltaic cell, an organic photodetector, an organic transistor, an organic or hybrid solar cell, an organic diode, an organic laser diode, an organic sensor, an organic field effect transistor or an organic battery.

A further object of the invention is a compound of formula (I)

[Ce⁴⁺] L_{A}²⁻L_{B}²⁻ (I),

wherein L_{A}, L_{B} are independently of each other a tetradentate ligand with at least 26 carbon atoms,
wherein L_{A}, L_{B} are each coordinating with at least four Oxygen atoms to Ce⁴⁺, wherein L_{A}, L_{B} have the same or different meanings.

According to one embodiment, L_{A}, L_{B} are each coordinating with exactly four Oxygen atoms to Ce⁴⁺.

A further object of the invention is a doped semiconductor layer comprising at least one electron donor and at least one doping agent, wherein the doping agent is a compound of the formula (I) according to the invention. In a preferred embodiment, the electron donor is a triaryl amine-based or a carbazole compound, comprising at least one or more nitrogen atoms exhaustively substituted by aromatic moieties. The doping agent which is a compound of formula (I) preferably comprises a substituent according to one of the formulas (III.a) to (III.g), in particular a substituent according to formula (III.a) or (Ill.d), as an option a substituent according to formula (III.a), according to one embodiment a substituent according to formula (III.d).

A further object of the invention is a use of at least one compound of formula (I), preferably comprising a substituent according to one of the formulas (III.a) to (Ill.g) .
- as a redox doping agent in semiconductor layers, especially as p-dopant in hole transport layers,
- as p-dopant in hole transport layers,
- as charge injector in a charge injection layer,
- as charge extractor in a charge extraction layer,
- as semiconductor, in particular as organic semiconductor,
- as a sublayer of a pn-junction, especially as a sublayer of a charge-generation layer and/or a charge conversion layer, in particular a p-type charge generation layer,
- as acceptor compound in charge-transfer complexes,
- as cathode material in organic and/or redox flow batteries,
- as electrochromic material.

A further object of the invention is a use of at least one compound of formula (I), as doping agent for the doping of a semiconductive layer, as absorbing layer, as charge injection layer, or as charge transport layer, or as semiconductor itself.

A further object of the invention is a use of reduced species and/or twice reduced species of the compound of the general formula (I) as defined herein or of charge transfer complexes of a compound of formula (I) as defined herein with electron donors as semiconductor or as electrochromic material.

A further object of the invention is a method for the preparation of a doped semiconductor layer, wherein a hole transport material and a compound of general formula (I) according to the invention is used. The method comprises at least one of the following steps:
(a) Simultaneous evaporation of the hole transport material and the compound of formula (I).
(b) Evaporation of a pre-mixed material containing the hole transport material and at least one compound of general formula (I) from one single source.
(c) Sequential deposition of the hole transport material and at least one compound of general formula (I).
(d) Doping of a hole transport (HT) layer by a solution containing at least one compound of general formula (I) followed by evaporation of the solvent by thermal treatment.
(e) Surface doping of a layer of a hole transport material by a layer of at least one compound of general formula (I) applied to one or both surfaces of the layer of a hole transport material.
(f) Preparing a solution of a hole transport material and at least one compound of general formula (I) and forming a film from the solution.

The invention will be illustrated further with reference to the examples that follow, without restricting the scope to the specific embodiments described. The invention includes all combinations of described and especially of preferred features that do not exclude each other.

### DESCRIPTION OF THE INVENTION

The invention has the following advantages:
- The compounds of formula (I) have advantageously low production costs.
- The compounds of formula (I) have a wide application range, in particular the compounds of formula (I) can be used for a p-side application in organic electronic devices
- The compounds of formula (I) are advantageously suitable as electron acceptors for use as p-dopants and as electron transport materials in organic-electronic components.
- The compounds of formula (I) according to the invention lead to a better conductivity of the semiconductor layers as compared to known electron acceptors.
- Furthermore, the compounds of formula (I) are characterized by a higher doping efficiency.
- Doped layers comprising a matrix material and a compound of formula (I) show only a low absorption, in particular in the visible range and in the near-infrared range. Therefore, parasitic absorption and emission can be reduced or even prevented.
- The compounds of formula (I) show good evaporation behavior in high vacuum during processing, in particular a high evaporation temperature.
- The compounds of formula (I) show long-term thermostability during processing.
- The compounds of formula (I) are suitable for the production of organic and hybrid opto-electronic components, both by means of solvent processing and by vacuum reprocessing.

The expression "halogen" denotes in each case fluorine, bromine, chlorine or iodine, preferably fluorine, chlorine and bromine.

In the context of the invention, the prefix Cₙ-Cₘ indicates the number n and m, respectively, of carbon atoms that a molecule or residue designated thereby may contain.

In the context of the invention, alkyl refers to unbranched or branched saturated hydro-carbon groups.

In the context of the invention, the term "cycloalkyl" refers to unbranched or branched saturated cyclic hydro-carbon groups. Examples are cyclohexyl, cyclopentyl, methylcyclohexyl.

In the context of the invention, "haloalkylaryl" refers to mono- or polynuclear aromatic hydrocarbon radicals with usually 6 to 14, especially preferably 6 to 10 carbon atoms with polyhalogenated side chains. Examples of haloalkylaryl are trifluoromethylphenyl, trifluoromethylnaphtyl.

In the context of the invention, the expression C₁-C₄-alkyl refers to unbranched or branched saturated hydrocarbon groups having 1 to 4 carbon atoms. C1-C4-alkyl are e.g. methyl, ethyl, propyl, 1-methylethyl, butyl, 1-methylpropyl or 2-methylpropyl, 1,1-dimethylethyl.

The expression "aryl" comprises in the context of the invention mono- or polynuclear aromatic hydrocarbon radicals with usually 6 to 14, especially preferably 6 to 10 carbon atoms. Examples of aryl are especially phenyl, naphthyl, indenyl, fluorenyl, anthracenyl, phenanthrenyl, naphthacenyl, chrysenyl, pyrenyl, etc. and especially phenyl or naphthyl.

The term heteroaryl (hetaryl) includes mono- and polycyclic (e.g. bicyclic or tricyclic) heteroaromatic radicals having 3 to 13 carbon atoms, wherein hetaryl has 1, 2, 3 or 4 identical or different heteroatoms or heteroatom-containing groups as ring members, selected from N, O, S, SO and SO₂, preferably selected from N, O and S. The hetaryl group may be attached to the remainder of the molecule via a ring carbon or via a ring heteroatom e.g. via a nitrogen. Examples of 5- or 6-membered aromatic hetero-cyclic rings (also called heteroaromatic rings or hetaryl) are 2-pyrrolyl, 3-pyrrolyl, 3-pyrazolyl, 4-pyrazolyl, 5-pyrazolyl, 2-imidazolyl, 4-imidazolyl, 1,3,4-triazol-2-yl, 2-pyridinyl, 3-pyridinyl, 4-pyridinyl, 3-pyridazinyl, 4-pyridazinyl, 2-pyrimidinyl, 4-pyrimidinyl, 5-pyrimidinyl and 2-pyrazinyl. Examples of 10-membered aromatic heterocyclic rings are 2-quinolinyl, 3-quinolinyl, 1-isoquinolinyl.

In the context of the invention, the term "arylene" refers to arylene groups which are bivalent groups derived from aryl groups by removal of a further hydrogen atom from a further ring carbon atom, wherein the aromatic hydrocarbon biradicals have usually 6 to 14, especially preferably 6 to 10 carbon atoms . A synonym is arenediyl groups. It represent in particular any monocyclic or polycyclic hydrocarbon group comprising at least one aromatic cycle wherein all ring-atoms are carbon, from which two hydrogen have been removed to create a divalent group. Aylene groups can be partially or fully substituted. Examples of arylene are 1,3-phenylene, 1,2-phenylene 1,2-naphtylene, 1,5-naphthylene, 1,7-naphthylene, 4,4'-biphenyl, 3,3'-biphenyl, 3,7-fluorene.

In the context of this invention, the term "heteroarylene" (hetarylene) refers to heteroarylene groups which are bivalent (biradical) groups derived from heteroaryl groups. The heteroaromatic biradicals have 3 to 13 carbon atoms, wherein hetarylene has 1, 2, 3 or 4 identical or different heteroatoms or heteroatom-containing groups as ring members, selected from N, O, S, SO and SO₂, preferably selected from N, O and S. Hetarylene groups can be partially or fully substituted. The hetarylene group may be attached to the remainder of the molecule via a ring carbon or via a ring heteroatom e.g. via a nitrogen. Examples of hetarylene include 2,6-pyridylene, 2,4-pyrimidylene, 2,5-pyrazinylene, or 2,5-thiophenylene.

In the context of the invention, the term "alkylene" refers to alkylene groups which are bivalent groups derived from alkyl groups by removal of a further hydrogen atom. Alkylene groups are for example methylene, ethylene, n-propylene and n-butylene.

In the context of the invention, the term "haloalkylene" refers to haloalkylene groups which are bivalent groups derived from partially or fully halogenated alkyl groups by removal of a further hydrogen atom. Alkylene groups are for example difluoromethylene, tetraflurorethylene, hexafluoropropylene and octafluorobutylene.

In the context of the invention, formula (II) represents an exemplary mesomeric frontier structure to which the ligands L are not restricted.

In the context of the invention, a tetradentate ligand is a ligand that binds to an individual metal atom (cerium atom) with four atoms.

The term charge transfer complexes describe a supramolecular assembly of an electron donor, for example an hole transport material and an electron acceptor, for example a p-dopant.

The expression "CN" denotes the cyano group (-C=N).

The expression "haloalkyl" refers to partially or fully halogenated alkyl chains. In other words, one or more hydrogen atoms, for example 1, 2, 3, 4 or 5 hydrogen atoms bonded to one or more carbon atoms of the alkyl-rest, are replaced by a halogen atom, in particular by fluorine or chlorine.

In the context of the invention, the term "cyclohaloalkyl" refers to unbranched or branched saturated cyclic hydro-carbon groups, which are partially or fully halogenated. In other words one or more hydrogen atoms, for example 1, 2, 3, 4 or 5 hydrogen atoms bonded to one or more carbon atoms of cycloalkyl-residue are replaced by a halogen atom, in particular by fluorine or chlorine.

### COMPOUNDS OF FORMULA (I)

According to the invention the compound is represented by formula (I)

[Ce⁴⁺] L_{A}²⁻L_{B}²⁻ (I),

wherein L_{A}, L_{B} are independently of each other a tetradentate ligand with at least 26 carbon atoms,
wherein L_{A}, L_{B} are each coordinating with at least four Oxygen atoms to Ce⁴⁺, wherein L_{A}, L_{B} have the same or different meanings.

According to one embodiment, each of L_{A}, and L_{B} has at least 32 carbon atoms.

According to one embodiment, each of L_{A}, and L_{B} exclusively coordinates with oxygen.

According to one embodiment, L_{A}, L_{B} are coordinating with exactly four oxygen atoms to Ce⁴⁺.

According to a preferred embodiment, L_{A}, L_{B} are each tetradentate ligands independently selected from formula (II) 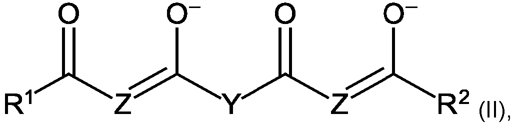 wherein
Z is the same or different at each instance selected from C-H, C-D, C-CF₃ and C-R³;
R¹, R², and R³ independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₃-C₆-cycloalkyl, C₃-C₆-cyclohaloalkyl or C₁-C₆-haloalkyl,
   wherein aryl and heteroaryl are unsubstituted or substituted by 1, 2, 3, 4 or 5 identical or different radicals R⁴;
   wherein R⁴ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
Y is selected from the formula (III.a) to (III.g) 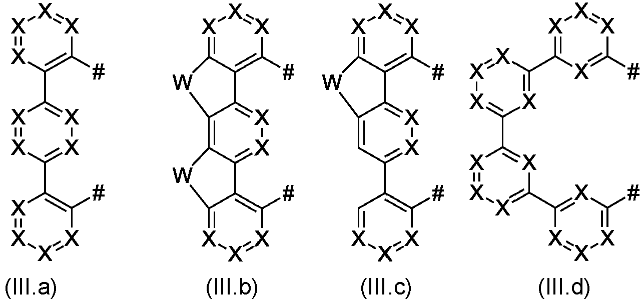 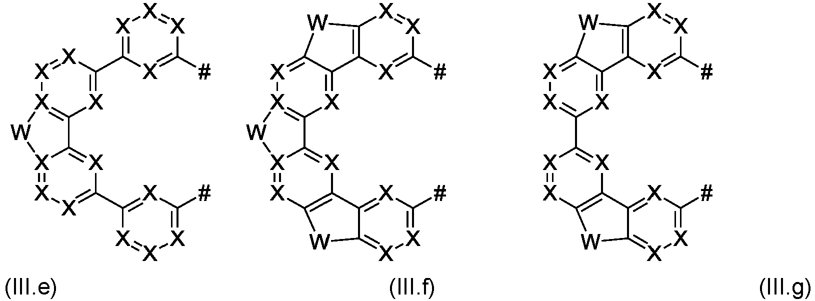
wherein # denotes the bond to the remaining molecule of formula (II),
wherein
X is the same or different at each instance selected from C-H, C-CF₃ and C-R⁵;
   wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.
W is the same or different at each instance and is S,O, -CO-, -SO2-, -CR⁶=CR⁶-, -C(R⁶)2-C(R⁶)2-, -C(R⁶)₂-, -POR⁷-
   wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.
   wherein R⁷ is selected from C₆-C₁₂-aryl or C₄-C₁₀-heteroaryl, which is unsubstituted or substituted by 1, 2 or 3 identical or different radicals selected from F, CN, C₁-C₄-alkyl and C₁-C₄-haloalkyl.

In one embodiment, Z is C-H.

In one embodiment, Y is selected from formulas (Ill.a) and (Ill.d), as an option Y is a substituent according to formula (III.a), as another option Y is a substituent according to formula (Ill.d).

In one embodiment, Z is C-H, and Y is selected from formulas (III.a) and (III.d), as an option Z is C-H and Y is a substituent according to formula (III.a), as another option Z is C-H and Y is a substituent according to formula (III.d).

In one embodiment, L_{A} and L_{B} have the same meaning.

In one embodiment, Z is C-H, and L_{A} and L_{B} have the same meaning.

In one embodiment, Y is selected from formulas (III.a) and (III.d), and L_{A} and L_{B} have the same meaning, as an option Y is a substituent according to formula (III.a) and L_{A} and L_{B} have the same meaning, as another option Y is a substituent according to formula (III.d) and L_{A} and L_{B} have the same meaning.

In one embodiment, Z is C-H, Y is selected from formulas (III.a) and (III.d), and L_{A} and L_{B} have the same meaning, as an option Z is C-H and Y is a substituent according to formula (III.a) and L_{A} and L_{B} have the same meaning, according to one embodiment Z is C-H and Y is a substituent according to formula (III.d) and L_{A} and L_{B} have the same meaning.

In another embodiment, L_{A} and L_{B} have a different meaning.

In one embodiment, R¹ and R² are identical.

In one embodiment, R¹ and R² are selected from C₁-C₆-haloalkyl.

In one embodiment, R¹ and R² are identical and selected from C₁-C₆-haloalkyl. For example, R¹ and R² are selected from CF₃, C₂F₅, n-C₃F₇, n-C₄F₉, preferably from CF₃, C₂F₅, and n-C₃F₇.

According to one embodiment, R¹ is C₁-C₆-haloalkyl, optionally R¹ is selected from CF₃, C₂F₅, and n-C₃F₇.

Preferred are compounds, according to formula (I), wherein L_{A}, L_{B} are each tetradentate ligands independently selected from formula (II) 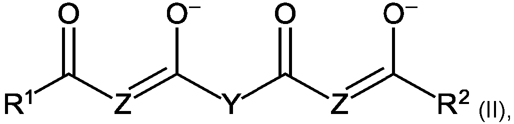 wherein each of R¹ and R² can be independently selected from CF₃, C₂F₅, n-C₃F₇, n-C₄F₉ and Y can be selected from one of the formulas (III.1) - (III.50): 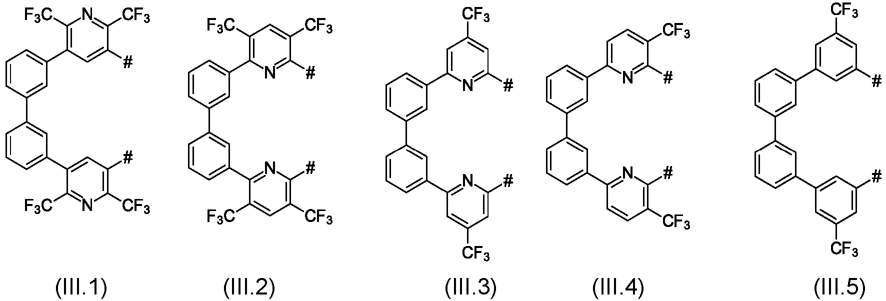 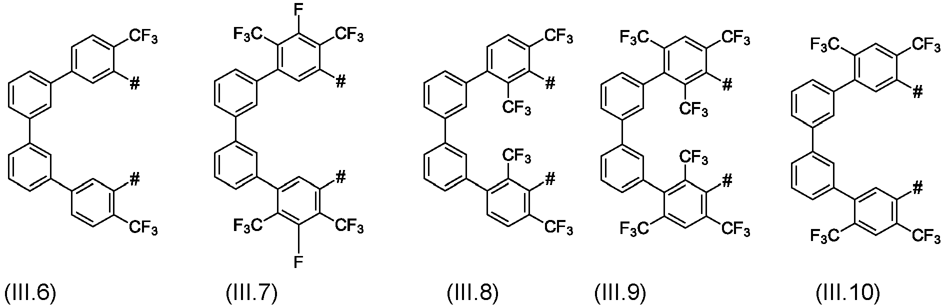 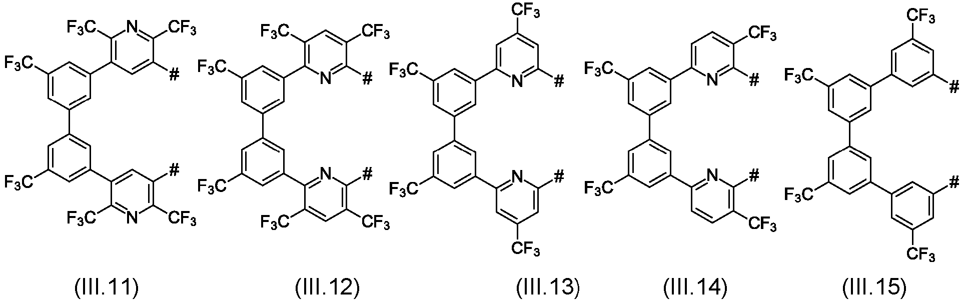 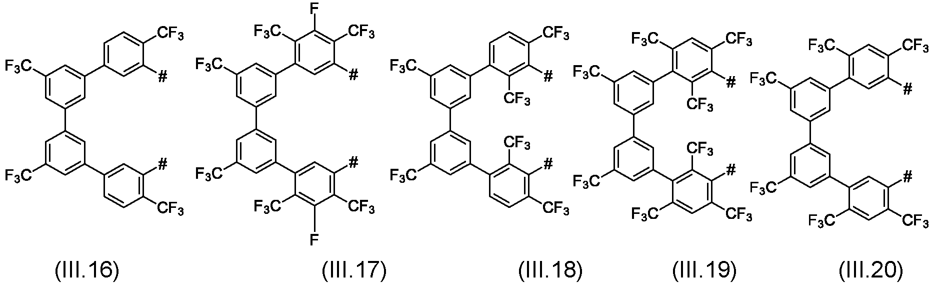 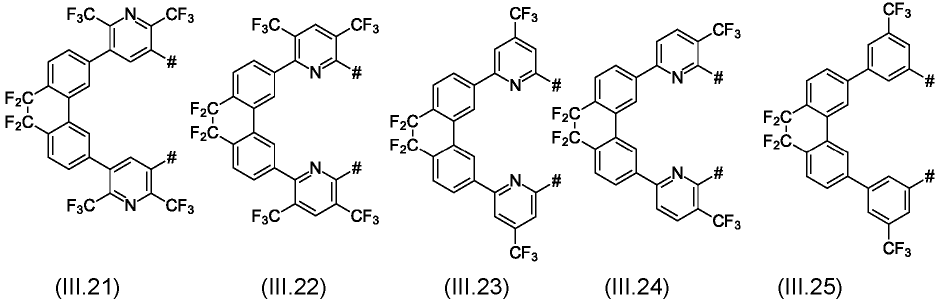 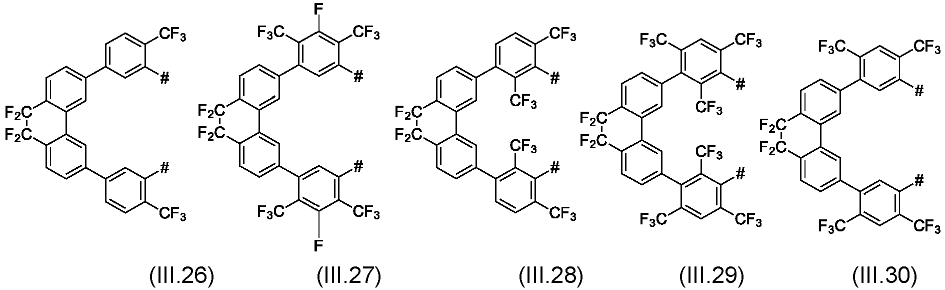 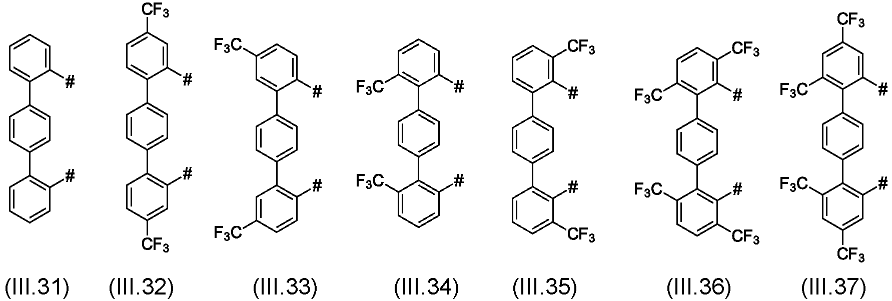 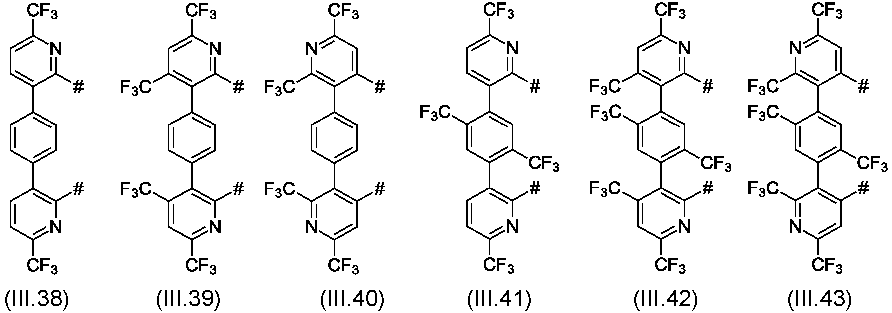 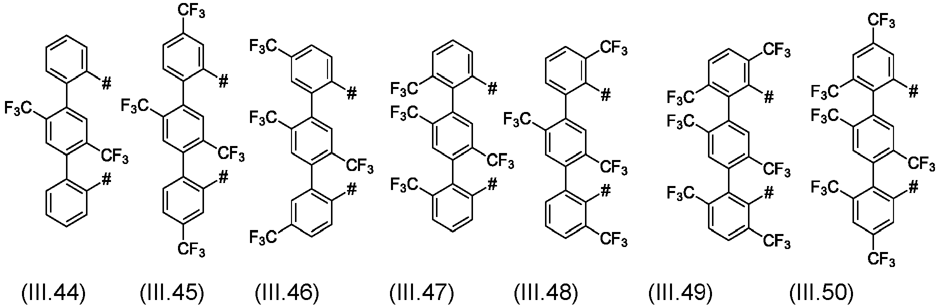 wherein # denotes the bond to the remaining molecule of formula (II). Preferably Y is selected from one of the formulas (III.7), (III.15), (III.17), and (III.25).

In one embodiment, R¹ and R² are identical and selected from C₁-C₆-haloalkyl, preferably from CF₃, C₂F₅, n-C₃F₇, n-C₄F₉, more preferably from CF₃, C₂F₅, and n-C₃F₇, and Y is selected from one of the formulas (III.7), (111.15), (111.17), and (III.25).

### ELECTRONIC COMPONENT

In the context of the invention, an electronic component is understood to be a discrete or integrated electrical component that utilizes the properties of compounds of the general formula (I) or semiconductor layers that contain a compound of the general formula (I).

In the context of the present specification the term "compound of the general formula (I)" means a compound that corresponds to the formula (I) according to the invention as defined herein. An electronic component which comprises a compound of the general formula (I) may comprise each compound which is included in one of the preferred embodiments of the compounds as described herein. This also applies to the term "compound of the formula (I)".

All specifications for the compounds and preferred embodiments of the compounds apply analogously to the electronic component.

In a particular embodiment, the electronic component has a layered structure comprising 2 to 50 semiconductor layers, preferably 3 to 30 semiconductor layers, more preferably 5 to 20 semiconductor layers, wherein at least one of the semiconductor layers comprises at least one compound of general formula (I). Preferably, at least one of the semiconductor layers comprises organic material. However, each of the layers may also comprise inorganic materials, or the component may also comprise layers composed entirely of inorganic materials.

Preferably, the electronic component is selected from
- a light-emitting device, preferably a light-emitting electrochemical cell or an organic electroluminescent device, more preferably an organic light-emitting diode (OLED), especially a single-stack organic light-emitting diode, a tandem-stack organic light-emitting diode, a triple-stack organic light-emitting diode, or a quadrupole-stack organic light-emitting diode,
- a lighting device,
- a display device,
- a photovoltaic cell, preferably an organic solar cell, preferably a single-stack organic solar cell, a tandem-stack organic solar cell, a triple-stack organic solar cell, a quadrupole-stack organic solar cell, a Perovskite solar cell, or a dye sensitized solar cell,
- an organic photodetector,
- an organic transistor, preferably organic thin-film transistors (OTFTs),
- an organic diode,
- an organic laser diode,
- devices for electrophotography, or - a battery.

In the context of the present invention, a lighting device refers to an electrically operable component or assembly designed to emit light for the purpose of illuminating interior or exterior areas of a building or a vehicle, preferably a motor vehicle. The lighting device comprises at least one light source, e.g. an organic light emitting diode and a housing and/or mounting structure, and it optionally comprises optical elements, e.g. lenses and/or reflectors and/or diffusers, and it may optionally comprise control electronics for modulating light characteristics such as intensity, direction, color, and/or beam pattern.

The lighting device may be integrated into a vehicle component. Such a vehicle component may be selected from but is not limited to headlamp, taillamp, interior ambient lighting, daytime running light, or a projection system. The lighting device may further support adaptive or dynamic lighting functions based on sensor input, vehicle state, or user settings. More preferably, the electronic component according to the invention is in the form of an organic light-emitting diode, an organic solar cell, a perovskite solar cell, an organic photodiode or an organic thin-film transistor.

In a preferred embodiment the electronic component according to the invention comprises at least one p-type semiconductor layer, which comprises at least one or more of the compounds of formula (I). The p-type semiconductor layer comprising one or more of the compounds of formula (I) may be a hole injection layer and/or a hole transport layer and/or a hole extraction layer and/or a p-type charge charge-generation layer. The p-type semiconductor layers may comprise the same or different compounds of formula (I). One or more p-type semiconductor layers may also comprise p-dopants different from formula (I), e.g., from list (I) below.

The p-type semiconductor layer comprising a compound of formula (I) may also comprise a semiconductor matrix material.

Preferably, the semiconductor matrix material is selected from
- A fully or partially substituted triaryl amine and its derivatives
- A fully or partially substituted carbazol derivative
- A hole transport material that has for example a HOMO-level of less than -4.8 eV measured with cyclic voltammetry as described herein
- A hole transport material that has for example a HOMO-level higher than -6.0 eV measured with cyclic voltammetry as described herein
- A hole transport material that has a HOMO-level shallower than the HOMO-level of BPAPF, when measured with the same method
- A hole transport material that has a HOMO-level deeper than or equal to the HOMO-level of BPAPF, when measured with the same method
- A hole transport material that has partially or fully substituted thiophene units or is an oligo- or polythiophene
- A hole transport material that consists of partially or fully substituted aryl or heteroaryl rings, but does not contain any triarylamine functional units
- A hole transport material that includes substituted carbazole units
- A semiconductor matrix material selected according to EP3859808

Preferably, the electronic component comprises a substrate (a metal, glass, or plastic substrate), an anode layer with or without sublayers, and a cathode layer. More preferably, the electronic component also comprises at least one photoactive layer. The at least one photoactive layer may be a light-emitting layer or a light-absorbing layer.

The anode layer may be composed of a metal, preferably Al or Ag, or a transparent conductive oxide, preferably indium tin oxide (ITO). The anode layer may comprise a first and a second sub-layer, preferably the first sub-layer comprises a metal with a work function between 3 eV and 7 eV, preferably between 4 eV and 6 eV, and the second sub-layer comprises a transparent conductive oxide, and the second sub-layer is closer to the hole injection layer. The second sub-layer may also comprise a metal nitride, preferably titanium nitride. The anode layer may also comprise three sublayers, preferably the first and third sublayer comprise ITO and the second sublayer comprises Ag.

The electronic component may specifically be an organic electroluminescent device, particularly in the form of an organic light-emitting diode (OLED). An organic electroluminescent device comprises a cathode, an anode and at least one emitting layer. It may also include other layers in addition to these layers, for example, one or more each of hole injection layers, hole transport layers, hole blocking layers, electron transport layers, electron injection layers, electron blocking layers, exciton blocking layers, charge conversion contacts and/or charge generation layers, both also referred to as pn-junctions. Not each of these layers must necessarily be present.

In a preferred embodiment, an electronic component, particularly in the form of an OLED, the layer comprising at least one of the compounds of formula (I) is a hole injection layer. A hole injection layer is generally a layer that facilitates hole injection from the anode into the organic semiconductor layer. The hole injection layer can be placed directly adjacent to the anode. The hole injection layer may be purely composed of a compound of formula (I). Preferably, the hole injection layer is composed of a semiconductor matrix material and one or more compound(s) of formula (I). The hole injection layer may be composed of a first sub-layer comprising a compound of formula (I) and a second sub-layer comprising a semiconductor matrix material, wherein the first sub-layer is closer to the anode and the second sub-layer is closer to the emitting layer. The first sub-layer may also consist of a compound of formula (I). The second sub-layer may or may not comprise a compound of formula (I) in addition to a semiconductor matrix material.

In a preferred embodiment, an electronic component, particularly in the form of an OLED, the layer comprising at least one of the compounds of formula (I) is a **hole transport layer.** Preferably, the hole transport layer is composed of a semiconductor matrix material and one or more compound(s) of formula (I). Specifically, the hole transport layer may be located between a hole injection layer and an emitting layer, where it transports holes from the anode to the emitting layer. Between the hole transport layer and the emitting layer may be other layers, such as electron blocking layers, exciton blocking layers, and prime layers. In another embodiment, the hole transport layer is located between an electrode and an emission layer, where it transports holes from the electrode to the emission layer.

In another embodiment, preferably a multi-stack OLED, preferably a tandem- or triple- or quadruple-stackOLED, the hole transport layer transports holes from a charge generation layer to an emitting layer. Between the hole transport layer and the emitting layer may be other layers, such as electron blocking layers, exciton blocking layers, and prime layers.

The hole-injection layer and/or hole-transport layer in an electronic component according to the invention may also comprise a second p-dopant different from compounds of formula (I), for example each of the layers may also comprise doping materials selected from the following list (I).

### List (I):

The class of 3-radialenes, preferrably α,α',α"-1,2,3-Cyclopropanetriylidenetris[4-cyano-2,3,5,6-tetrafluorobenzeneacetonitrile], from the class of dicyanochinodimethane-derivatives, preferrably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile].

The second p-dopant may be present in the same or a different layer or sub-layer than the compound of formula (I), preferably the compounds according to one of the formulas (III.a) to (Ill.g).

The electronic component may also, in addition, include a pn-junction or a charge-generation layer, which comprises a second p-dopant. The second p-dopant may be a compound different from formula (I), e.g. selected from list (I).

In a preferred embodiment, an electronic component, particularly in the form of a multi-stack OLED, e.g., a tandem or triple or quadruple-stack OLED, the layer comprising the compound of formula (I) is part of a pn-junction, particularly in form of a charge-generation layer. The pn-junction may be composed of a p-type charge-generation layer, an n-type charge-generation layer, and optionally one or more interlayers. Preferably, the layer comprising a compound of formula (I) is the p-type charge-generation layer. Preferably, this p-type charge-generation layer is composed of a semiconductor matrix material and one or more compound(s) of formula (I). A compound of formula (I) may also be used in an interlayer. The p-type charge-generation and/or the interlayer may also be composed of a compound of formula (I).

The electronic component may also, in addition, include a hole injection and/or hole-transport layer, which comprise(s) at least a second compound of formula (I). The second compound of formula (I) may be the same or different from the compound of formula (I) comprised in the pn-junction.

The electronic component may also, in addition, include a hole injection and/or hole-transport layer, which comprises a p-dopant different from compounds of formula (I), e.g. selected from list (I).

Advantageously, the application of two or more different p-dopants in the hole-injection layer, hole-transport layer, and/or pn-junction allows to reduce the leakage current, i.e. the pixel crosstalk can be reduced, while also ensuring a good OLED performance, such as low operating voltage and a good voltage stability.

Advantageously, using two or more different p-dopants in the hole-injection layer, hole-transport layer, and/or pn-junction allows to increase the OLED efficiency by reducing parasitic absorption, while also ensuring a low operating voltage and a good voltage stability.

Preferably, the electronic component according to the invention is in the form of an organic or hybrid solar cell, which are exciton solar cells, dye sensitized solar cells (DSSCs) or perovskite solar cells.

A preferred embodiment is an electronic component in the form of an organic solar cell. Organic solar cells generally have a layered structure and typically include at least the following layers: anode, at least one photoactive layer and cathode. The photoactive region of the solar cell may comprise two layers, each having a homogeneous composition and forming a planar donor-acceptor heterojunction. A photoactive region may also comprise a mixed layer and form a donor-acceptor heterojunction in the form of a donor-acceptor bulk heterojunction. In addition to these layers, the organic solar cell may also comprise other layers, e.g., selected from electron extraction layer, hole extraction layer, electron transport layer (ETL), hole transport layers (HTL), exciton blocking layer, hole blocking layer, electron blocking layers, charge conversion layer, also referred to as charge recombination layer, optical spacers, and multiplier layers. Preferably, these layers do not absorb UV-visible light.

A preferred embodiment is an electronic component, particularly in the form of an organic solar cell, wherein the layer comprising at least one of the compounds of formula (I) is a hole extraction layer. Preferably, this hole extraction layer is composed of a semiconductor matrix material and one or more compound(s) of formula (I). The hole extraction layer may be placed directly adjacent to the anode. The electronic component may also, in addition, include a pn-junction or charge-conversion layer, which comprises a p-dopant different from compounds of formula (I), e.g. selected from list (I).

A preferred embodiment is an electronic component, particularly in the form of an organic solar cell, wherein the layer comprising at least one of the compounds of formula (I) is a hole transport layer. Preferably, this hole transport layer is composed of a semiconductor matrix material and one or more compound(s) of formula (I). The hole transport layer may be placed between a photoactive layer and an anode or between a photoactive layer and a charge conversion layer or a charge recombination layer. The electronic component may also, in addition, include a pn-junction or charge-generation layer, which comprises a p-dopant different from compounds of formula (I), e.g. selected from list (I).

Preferably, the electronic component according to the invention is in the form of an organic solar cell, particularly in the form of a single, tandem, triple or quadruple-stack organic solar cell, wherein the layer comprising at least one of the compounds of formula (I) is a pn-junction. The pn-junction may be a charge conversion or recombination contact, connecting a light-absorbing unit to an additional light-absorbing unit in a multi-stack device and/or a pn-junction (or conversion contact) connecting a cathode or an anode to a light-absorbing unit in a single or multi-stack device. The electronic component may also, in addition, include a hole extraction and/or hole transport layer, which comprises a p-dopant different from compounds of formula (I), e.g. selected from list (I).

Preferably, the electronic component according to the invention is in the form of an organic photoactive sensor, in particular an organic photodetector. An organic photoactive sensor, in particular an organic photodetector can be composed of the same layers as an organic solar cell. Not necessarily all layers need to be present. The description of an organic solar cell according to the invention also applies to an organic photoactive sensor, in particular an organic photodetector.

Preferred are electronic components comprising at least one compound of the formula (I), or one of the compounds according to one of the formulas (III.a) to (Ill.g).

According to the invention, the electronic component comprises at least one compound of the formula (I)

[Ce⁴⁺] L_{A}²⁻L_{B}²⁻ (I),

wherein L_{A}, L_{B} are independently of each other a tetradentate ligand with at least 26 carbon atoms,
wherein L_{A}, L_{B} are each coordinating with at least four Oxygen atoms to Ce⁴⁺, wherein L_{A}, L_{B} have the same or different meanings.

According to one embodiment, each of L_{A}, and L_{B} has at least 32 carbon atoms.

According to one embodiment, each of L_{A}, and L_{B} exclusively coordinates with oxygen.

According to one embodiment, L_{A}, L_{B} are coordinating with exactly four oxygen atoms to Ce⁴⁺.

One embodiment of the electronic component is an electronic component comprising a compound of the general formula (I), wherein L_{A}, L_{B} are each tetradentate ligands independently selected from formula (II) 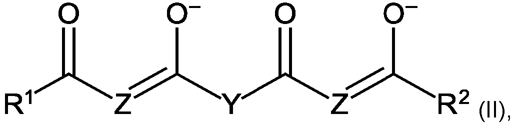 wherein
Z is the same or different at each instance selected from C-H, C-D, C-CF₃ and C-R³;
R¹, R², and R³ independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl, C₃-C₆-cyclohaloalkyl or C₁-C₆-haloalkyl,
   wherein aryl and heteroaryl are unsubstituted or substituted by 1, 2, 3, 4 or 5 identical or different radicals R⁴;
   wherein R⁴ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
Y is selected from the formula (III.a) to (III.g) 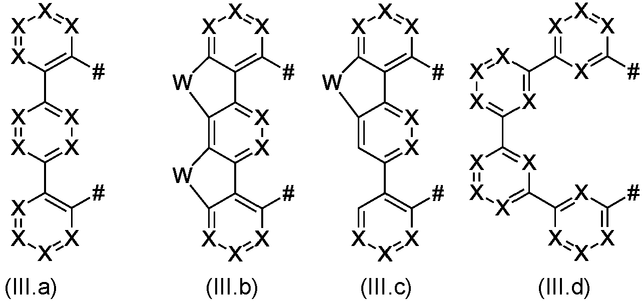 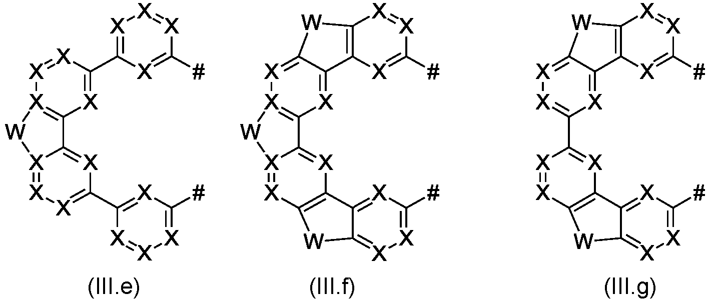
wherein # denotes the bond to the remaining molecule of formula (II),
   wherein
X is the same or different at each instance selected from C-H, C-CF₃ and C-R⁵;
   wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from **F,** CN, C₁-C₄-alkyl and C₁-C₄-haloalkyl,
wherein
W is the same or different at each instance and is S, O, -CO-, -SO₂-, -CR⁶=CR⁶-, - C(R⁶)2-C(R⁶)2-, -C(R⁶)₂-, -POR⁷-
   wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.
   wherein R⁷ is selected from C₆-C₁₂-aryl or C₄-C₁₀-heteroaryl, which is unsubstituted or substituted by 1, 2 or 3 identical or different radicals selected from F, CN, C₁-C₄-alkyl and C₁-C₄-haloalkyl.

A ligand containing 26 carbon atoms is for example represented by formula (IV)

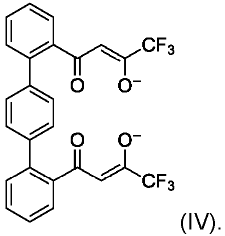

The compound of formula (I) is preferably electronically neutral, i.e. the compound of formula (I) is electrically non-charged.

Preferred is the electronic component according to the invention, wherein Y is selected from
the formulas (III.a) and (Ill.d).

In one embodiment, Z is C-H.

In one embodiment, Z is C-H, and Y is selected from formulas (Ill.a) and (Ill.d), in one embodiment Z is C-H, and Y is represented by formula (Ill.a), and in one embodiment Z is C-H, and Y is represented by formula (III.d).

In one embodiment, L_{A} and L_{B} have the same meaning.

In one embodiment, Z is C-H, and L_{A} and L_{B} have the same meaning.

In one embodiment, Y is selected from formulas (Ill.a) and (Ill.d), and L_{A} and L_{B} have the same meaning, optionally Y is represented by formula (III.a) and L_{A} and L_{B} have the same meaning, in one embodiment Y is represented by formula (III.d) and L_{A} and L_{B} have the same meaning.

In one embodiment, Z is C-H, Y is selected from formulas (Ill.a) and (Ill.d), and L_{A} and L_{B} have the same meaning.

As an option, Z is C-H, Y is represented by formula (Ill.a) and L_{A} and L_{B} have the same meaning.

In one embodiment Z is C-H, Y is represented by formula (Ill.d) and L_{A} and L_{B} have the same meaning.

In another embodiment, L_{A} and L_{B} have a different meaning.

In one embodiment, R¹ and R² are identical.

In one embodiment, R¹ and R² are selected from C₁-C₆-haloalkyl.

According to one embodiment, R¹ is C₁-C₆-haloalkyl, optionally R¹ is CF₃ or n-C₃F₇.

In one embodiment, R¹ and R² are identical and selected from C₁-C₆-haloalkyl. For example, R¹ and R² are selected from CF₃, C₂F₅, n-C₃F₇, n-C₄F₉, preferably from CF₃ and n-C₃F₇.

In one embodiment, the electronic component according to the invention, comprises a compound according to general formula (I), wherein each of R¹ and R² can be independently selected from CF₃, C₂F₅, n-C₃F₇, n-C₄F₉ and Y is selected from one of the formulas (III.1) - (III.50): 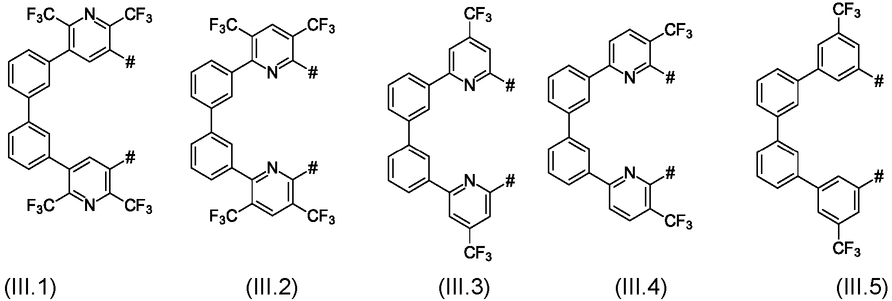 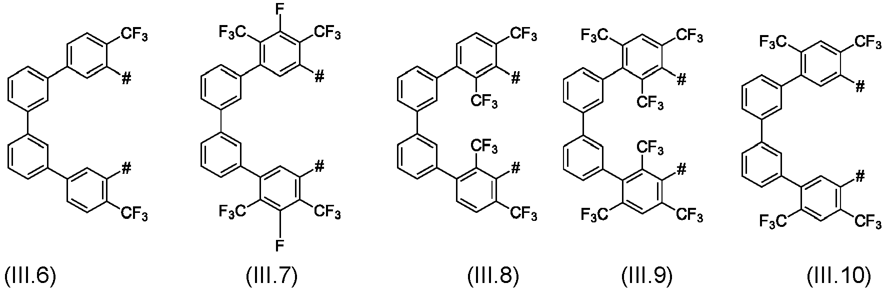 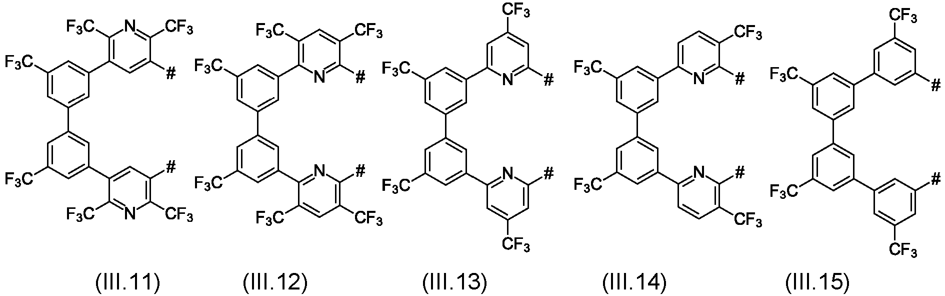 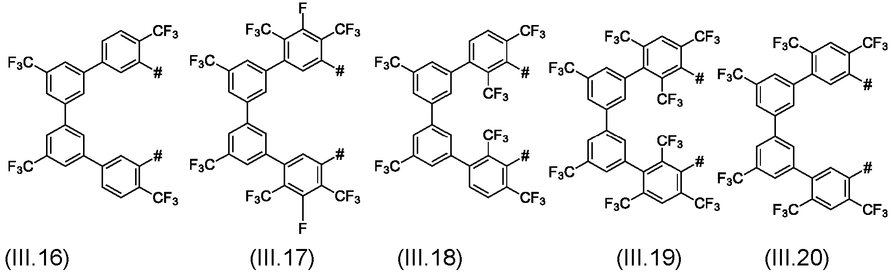 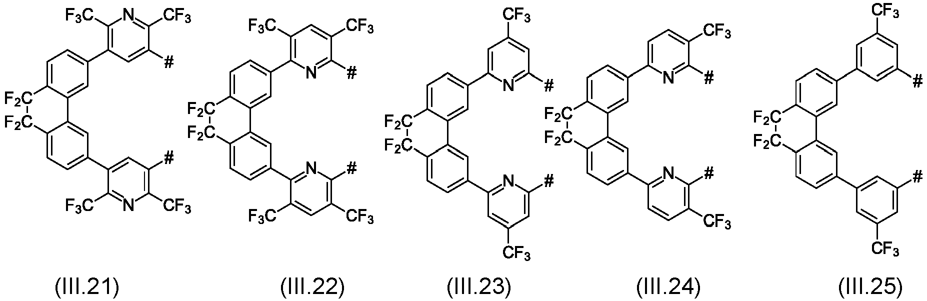 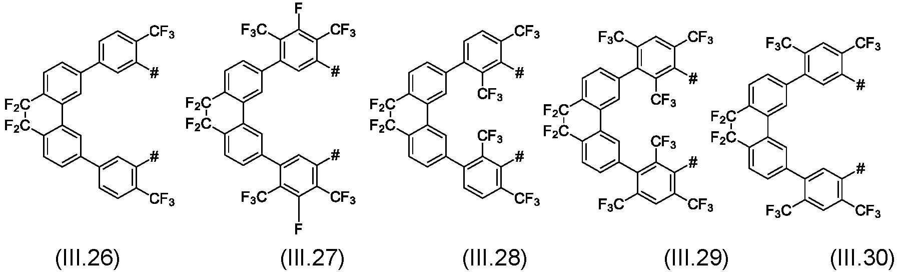 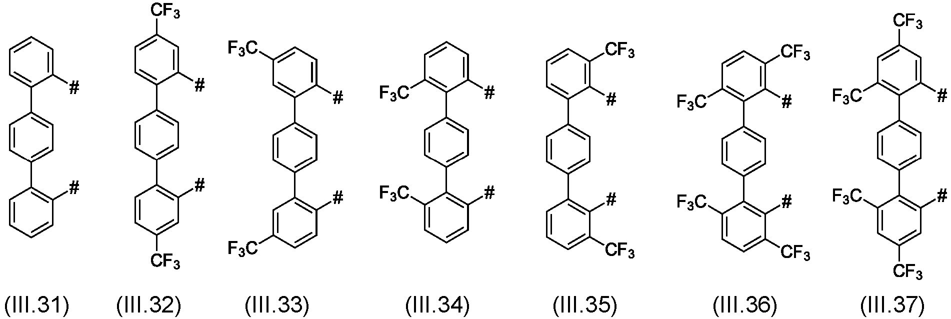 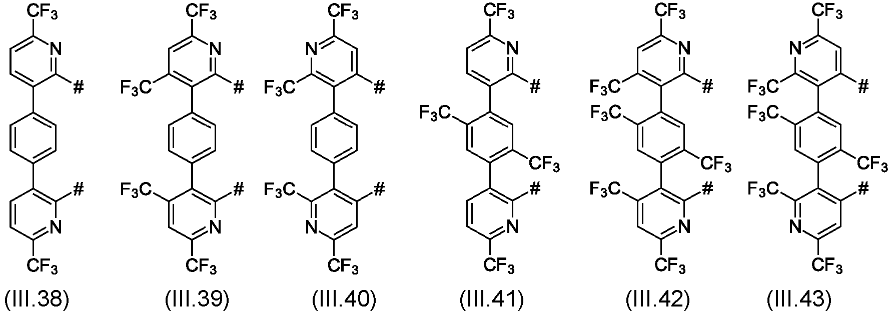 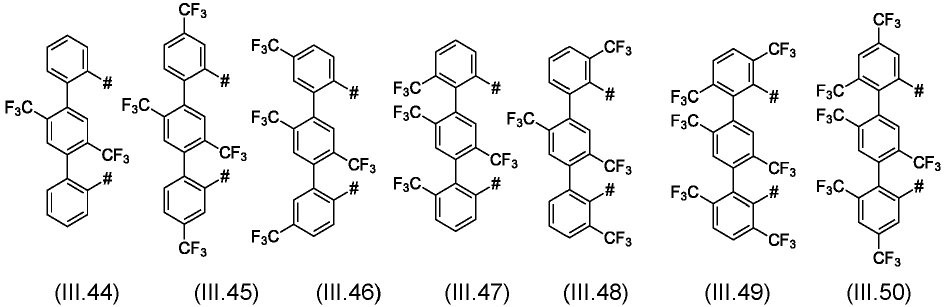 wherein # denotes the bond to the remaining molecule of formula (II). Preferably Y is selected from one of the formulas (III.5), (III.15), (III.20), (III.25) and (III.33).

In one embodiment, R¹ and R² are identical and selected from C₁-C₆-haloalkyl, preferably from CF₃, C₂F₅, n-C₃F₇, n-C₄F₉, more preferably from CF₃ and n-C₃F₇, and Y is selected from one of the formulas (III.5), (III.15), (III.25) and (III.33).

Preferred is the electronic component according to the invention which comprises at least one hole transport layer and/or at least one hole injection layer and/or at least one hole extraction layer and/or at least one pn-junction and/or one electron transport layer, which comprise at least one or more of the compounds of formula (I). The pn-junction may comprise at least a p-type charge generation layer and an n-type charge generation layer, wherein preferably the p-type charge generation layer comprises one or more compounds of formula (I).

### MATRIX MATERIALS

The compounds of the formula (I) according to the invention, the charge transfer complexes thereof, and the reduction products thereof can be used as dopants in semiconductor matrix materials, in particular as p-dopants in hole transport layers.

Another aspect of the invention is a doped semiconductor layer comprising at least one electron donor, which can also be referred to as semiconductor matrix material, and at least one doping agent, wherein the doping agent is one or more compounds of formula (I), and/or the charge transfer complexes thereof, and/or the reduction products thereof, preferably compounds according to one of the formulas (III.a) to (Ill.g).

According to the invention, a doped semiconductor layer is a combination of two sub-stances or two compounds, in particular, of an semiconductor matrix compound, and at least one doping agent. The doping agent serves as an electron acceptor.

The semiconductor matrix material or semiconductor matrix compound which may also be called the matrix material can consist partially (> 10 or > 25% by weight) or substantially (> 50 % by weight or > 75% by weight) or totally (> 99 %) of a metal phthalocyanine complex, a porphyrine complex, especially metal porphyrine complex, oligothiophene-, oligophenyl-, oligophenylene vinylene- or oligofluorene compound, in which the oligomer preferably comprises 2-500 or more, preferably 2-100 or 2-50 or 2-10 or more monomeric units. The oligomer can also comprise > 4, > 6 or > 10 or more monomeric units, in particular also for the above-indicated ranges, thus, e.g., 4 or 6-10 monomeric units, 6 or 10-100 monomeric units or 10-500 monomeric units. Polymeric matrix materials can also be used. The monomers and oligomers can be substituted or unsubstituted and even block- or mixed polymerizates of the cited oligomers can be present as well as a compound with a triarylamine unit or a carbazole unit or a spiro-bifluorene compound.

The cited semiconductor matrix materials can also be present in combination with each other, optionally also in combination with other matrix materials. The semiconductor matrix materials can have electron-donating substitutents such as alkyl- or alkoxy groups that have a reduced ionizing energy or reduce the ionizing energy of the semiconductor matrix material.

The metal phthalocyanine complexes or porphyrine complexes used as semiconductor matrix material can have a main group metal atom or subgroup metal atom. The metal atom Me can be coordinated 4-, 5- or 6-fold, e.g., in the form of oxo(Me=O), dioxo- (O=Me=O) imine-, diimine-, hydroxo-, dihydroxo-, amino- or diamino complexes, without being limited to them. The phthalocyanine complex or porphyrine complex can each be partially hydrogenated, however, the mesomeric ring system is preferably not disturbed. The phthalocyanine can contain, e.g., magnesium, zinc, iron, nickel, cobalt, magnesium, copper or vanadyl (=VO) as central atom. The same or other metal atoms or oxometal atoms can be present in the case of porphyrine complexes.

In one preferred embodiment the semiconductor matrix material is either selected from phthalocyanine metal (Me) complexes (MePc) or triarylamino based or carbazole based or thiopheno based hole transport materials (HTM).

In particular, such dopable hole transport materials HTM can be arylated benzidines, e.g., N,N'-perarylated benzidines or other diamines such as of the type TPD (in which one, several or all of the aryl groups can have aromatic heteroatoms), suitable arylated starburst compounds such as N,N',N"-perarylated starburst compounds such as the compound TDATA (in which one, several or all of the aryl groups can have aromatic heteroatoms). The aryl groups can comprise phenyl, naphthyl, pyridine, quinoline, isoquinoline, peridazine, pyrimidine, pyrazine, pyrazole, imidazole, oxazole, furan, pyrrole, indole or the like, especially for each of the above-cited compounds. The phenyl groups of the particular compounds can be partially or completely replaced by thiophene groups.

It is understood that even other suitable semiconductor matrix materials/ semiconductor matrix compounds, in particular hole-conducting materials can be used that have semi-conductive properties.

In particular a doped semiconductor matrix material comprises at least one semiconductor matrix material and at least one compound of the formula (I), wherein the semiconductor matrix materials is selected from4,4',4"-tris(N-(2-naphthyl)-N-phenyl-amino)triphenylamine (2-TNATA), 4,4',4"-tris(N-3-methylphenyl-N-phenyl-amino)triphenylamine (m-MTDATA), N,N,N',N'-tetrakis(4-methoxy-phenyl)benzidine (MeO-TPD), (2,2',7,7'-tetrakis-(N,N-diphenylamino)-9,9'-spirobifluorene (spiro-TTB), N,N'-bis(naphthalen-1-yl)-N,N'-bis(phenyl)-benzidine, N,N'-bis(naphthalen-1-yl)-N,N'-bis(phenyl)-9,9-spiro-bifluorene, 9,9-bis[4-(N,N-bis-biphenyl-4-yl-amino)phenyl]-9H-fluorene, 2,2'-bis[N,N-bis(biphenyl-4-yl)amino]-9,9-spiro-bifluorene, N,N'-((9H-fluoren-9,9-diyl)bis(4,1-phenylen))bis(N-([1,1'-biphenyl]-4-yl)-[1,1'-biphenyl]-4-amine) (BPAPF), N,N'-bis(phenanthren-9-yl)-N,N'-bis(phenyl)-benzidine, 1,3,5-tris{4-[bis(9,9-dimethyl-fluoren-2-yl)amino]phenyl}benzene, tri(terphenyl-4-yl)amine, N-(4-(6-((9,9-dimethyl-9H-fluoren-2-yl)(6-methoxy-[1,1'-biphenyl]-3-yl)amino)-1,3,3-trimethyl-2,3-dihydro-1H-inden-1-yl)phenyl)-N-(6-methoxy-[1,1'-biphenyl]-3-yl)-9,9-dimethyl-9H-fluoren-2-amine, N-([1,1'-biphenyl]-4-yl)-N-(4-(6-([1,1'-biphenyl]-4-yl(9,9-dimethyl-9H-fluoren-2-yl)amino)-1,3,3-trimethyl-2,3-dihydro-1H-inden-1-yl)phenyl)-9,9-dimethyl-9H-fluoren-2-amine, N,N-di([1,1'-biphenyl]-4-yl)-3-(4-(di([1,1'-biphenyl]-4-yl)amino)phenyl)-1,1,3-trimethyl-2,3-dihydro-1H-inden-5-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(9,9'-spirobi[fluoren]-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9'-spirobi[fluoren]-2-amine, N-(4-(6-(dibenzo[b,d]furan-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)dibenzo[b,d]furan-2-amine, 9-(4-(6-(9H-carbazol-9-yl)-1,3,3-trimethyl-2,3-dihydro-1H-inden-1-yl)phenyl)-9H-carbazole, N-([1,1'-biphenyl]-4-yl)-3-(4-([1,1'-biphenyl]-4-yl(4-methoxyphenyl)amino)phenyl)-N-(4-methoxyphenyl)-1,1,3-trimethyl-2,3-dihydro-1H-inden-5-amine, 3-(4-(bis(6-methoxy-[1,1'-biphenyl]-3-yl)amino)phenyl)-N,N-bis(6-methoxy-[1,1'-biphenyl]-3-yl)-1,1,3-trimethyl-2,3-dihydro-1H-inden-5-amine, N1-([1,1'-biphenyl]-4-yl)-N1-(4-(6-([1,1'-biphenyl]-4-yl(4-(diphenylamino)phenyl)amino)-1,3,3-trimethyl-2,3-dihydro-1H-inden-1-yl)phenyl)-N4,N4-diphenylbenzene-1,4-diamine, N,N-di([1,1'-biphenyl]-4-yl)-4'-(6-(4-(di([1,1'-biphenyl]-4-yl)amino)phenyl)-1,3,3-trimethyl-2,3-dihydro-1H-inden-1-yl)-[1,1'-biphenyl]-4-amine, N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N,N'-bis(9,9-dimethyl-fluoren-2-yl)-N,N'-diphenyl-benzidine (BF-DPB), N,N'-((9H-fluorene-9,9-diyl)bis(4,1-phenylene))bis(N-([1,1'-biphenyl]-4-yl)-[1,1'-biphenyl]-4-amine) (BPAPF), N4,N4,N4',N4'-tetrakis(9,9-dimethyl-9H-fluoren-2-yl)-[1,1'-biphenyl]-4,4'-diamine (TDMFB), N-([1,1'-biphenyl]-2-yl)-N-(9,9-dimethyl-9H-fluoren-2-yl)-9,9'-spirobi[fluoren]-2-amine, (2,7-bis[N,N-bis(4-methoxyphenyl)amino]-9,9-spirobi[9H-fluorene] (spiro-MeO-TPD), a mixture of N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine and N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-([1,1'-biphenyl]-4-yl)-9,9-dimethyl-N-(4-(9-phenyl-9H-carbazol-3-yl)phenyl)-9H-fluoren-2-amine and mixtures thereof.

### DOPING

In particular, the doping can be carried out such that the molar ratio of matrix molecules to the compound of the general formula (I), is in the range from 10000 : 1 to 1 : 1, preferably from 1000 : 1 to 2 : 1, particularly preferably from 100 : 1 to 5 : 1.

Preferably, the compounds according to the invention are characterized by a high doping efficiency.

Advantageously, the compounds according to the invention exhibit a low absorption when used in the doped layer. Thus, parasitic absorption and emission can be reduced or even prevented.

### EVAPORATION OF THE DOPING AGENTS AND PREPARATION OF THE DOPED SEMICONDUCTOR LAYER

A further object of the invention relates to the doping of the respective semiconductor matrix material (hereinafter also referred to as hole transport material HTM which can also be referred to as hole transport matrix) with the compounds of the general formula (I) according to the invention and used in accordance with the invention may be carried out by one or a combination of two or more than two of the following processes:
(a) Simultaneous evaporation of the hole transport material and the compound of the general formula (I), preferably in vacuum, preferably with one source for the HTM and one for at least one compound of general formula (I).
(b) Evaporation of a pre-mixed material containing the HTM and at least one compound of general formula (I) from one single source.
(c) Sequential deposition of the HTM and at least one compound of general formula (I). This process step is followed by diffusion of the dopant, i.e. the compound of the general formula (I) inward upon thermal treatment. The compound of general formula (I) might be deposited before or after HTM.
(d) Doping of a layer of HTM by a solution of at least one compound of general formula (I) followed by evaporation of the solvent by thermal treatment.
(e) Surface doping of a layer of a HTM by a layer of at least one compound of general formula (I) applied to one or both surfaces of the HT layer (hole transport layer), i.e. a layer containing a HTM.
(f) Preparing a solution of a HTM and at least one compound of general formula (I) and forming a film from the solution, e.g., by coating, casting, printing, or other film-forming techniques known to one skilled in the art.

The deposition rate on a substrate with the compound used in accordance with the invention can be determined, e.g., using a quartz thickness monitor, as is customarily used, e.g., in the production of OLEDs. In particular, the ratio of the deposition rates of matrix materials and doping agent can be measured by independent measurements of them using two separate quartz thickness monitors in order to adjust the doping ratio.

It is understood that the compounds used in accordance with the invention are preferably such that they evaporate more or less or practically non-decomposed. However, if necessary, even purposeful precursors can be used as doping source that release the compounds used in accordance with the invention, e.g., acid addition salts, e.g., of a volatile or non-volatile inorganic or organic acid, or their charge transfer complexes, which acids and/or electron donors are preferably not volatile or only slightly volatile or the charge transfer complex itself acts as doping agent.

The doping agent used according to the invention is preferably selected in such a manner that the semiconductive matrix material doped with it still has ≥20%, preferably ≥30%, especially preferably ≥50% or 60% of the conductivity (s/cm) of the value at 100°C after a temperature change of 100°C to RT (20°C).

Preferred is a method for the preparation of a doped layer according to the invention of a doped layer, which preferably has been prepared by the method according to the invention, wherein the doped matrix material is heated at a temperature of at least 50-120°C, preferably 80°-105°C, for a time of 1 - 500 minutes, preferably 5 to 200 minutes, more preferably 10 - 150 minutes, even more preferably 20 - 50 minutes.

Annealing of the deposited layers by heating, preferably at temperatures between 50°C and 120°C, preferably for 1 to 200 min, can advantageously further increase the conductivity of the doped semiconductor layer.

The doping can take place in such a manner that the doping agent is evaporated out of a precursor compound that releases the doping agent under heating and/or irradiation. The irradiation can take place by electromagnetic radiation, especially visible light, UV light or IR light, e.g., by laser light or also by other radiation types. The heat necessary for evaporation can substantially be made available by the irradiation and can also be radiated in a purposeful manner into certain bands of the compounds or precursors or compound complexes such as charge transfer complexes to be evaporated in order to facilitate the evaporation of the compounds by dissociation of the complexes by conversion into excited states. It is understood that the evaporation conditions described in the following are directed to those without irradiation and that uniform evaporation conditions are to be used for purposes of comparison.

For example, the following can be used as precursor compounds:
a) Mixtures or stoichiometric or mixed crystalline compounds of the doping agent and an inert, non-volatile substance, e.g., a polymer, molecular sieve, aluminum oxide, silica gel, and oligomers or another organic or inorganic substance with high evaporation temperature, in which the doping agent is bound primarily by van der Waals forces and/or hydrogen bridge bonding to this substance.
b) Mixture or stoichiometric or mixed crystalline compound of the doping agent and one non-volatile compound V more or less of the electron donor type, in which a more or less complete charge transfer occurs between the doping agent and the compound V as in charge transfer complexes with more or less electron-rich polyaromatics or heteroaromatics or another organic or inorganic substance with high evaporation temperature.
c) Mixture or stoichiometric or mixed crystalline compound of the doping agent and a substance that evaporates together with the doping agent and has the same or higher ionizing energy as the substance HT to be doped, so that the substance does not form a trap for holes in the semiconductor matrix material. According to the invention the substance can also be identical to the semiconductor matrix material here, e.g., be a metal phthalocyanine or benzidine derivative. Further suitable volatile co-substances such as hydroquinones, 1,4-phenylene diamines or 1-amino-4-hydroxybenzene or other compounds form quinhydrones or other charge transfer complexes.

### EXAMPLES

The following examples illustrate the invention without limiting it in any way.

### SYNTHESIS

### SYNTHESIS OF COMPLEX C3

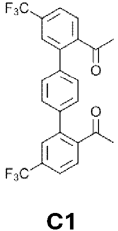

A mixture of benzene-1,4-diboronic acid (800 mg, 4.83 mmol), 1-[2-bromo-4-(trifluoromethyl) phenyl]ethanone (2.96 g, 11.1 mmol) and potassium carbonate (3.34 g, 24.1 mmol) in toluene (10 mL) and ethanol (5 mL) was flushed with nitrogen for 10 minutes. Tetrakis(triphenylphosphin)palladium(0) (279 mg, 0.24 mmol) was added and the resulting mixture was heated to 80 °C under nitrogen for 18 hours. Subsequently, the suspension was cooled to room temperature, water (50 mL) was added, and the aqueous phase was extracted with CH₂Cl₂ (3 x 30 mL). The combined organic phases were dried over Na₂SO₄. After evaporation of solvents the crude product was purified by column chromatography over silica (PE/EA =9:1 to 8:2) yielding bisacetophenone **C1** (1.63 g, 75%) as a white solid.

APCI-MS: m/z = 450.5 [M+H]⁺.

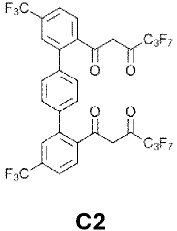

Sodium methoxide (469 mg, 8.69 mmol) was added in one portion to a solution of ethyl heptafluorobutanoate (2.10 g, 8.69 mmol) in MTBE (20 mL) at room temperature. After the resulting suspension was stirred for 10 minutes, bisacetophenone **C1** (1.63 g, 3.62 mmol) was added. After 17 hours 3 M aqueous HCl (100 mL) was added. The phases were separated, and the aqueous phase was extracted with MTBE (50 mL). The combined organic phases were dried over Na₂SO₄ and the solvents were removed under reduced pressure. The product was dried under vacuum yielding tetraketone **C2** (2.92 g, 96%) as an off-white solid.

APCI-MS: m/z = 841.7 [M]⁺.

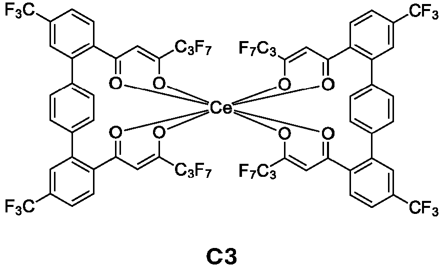

Sodium hydride (237 mg, 60% dispersion in mineral oil, 5.93 mmol) was added in one portion to a solution of tetraketone **C2** (2.90 g, 5.93 mmol) in acetonitrile (30 mL). The resulting mixture was stirred for ten minutes until gas evolution ceased. Subsequently, ceric ammonium nitrate (812 mg, 1.48 mmol) was added in one portion and the resulting mixture was stirred for 30 minutes. The reaction mixture was filtered, and the precipitate was washed with water (50 mL) and acetonitrile (50 mL). Recrystallization from a mixture of acetonitrile and chlorobenzene (50 mL, 4:1) afforded cerium complex **C3** (1.52 g, 49%) as a red-brown solid.

APCI-MS: m/z = 1818.4 [M-H]⁺.

### SYNTHESIS OF COMPLEX C7

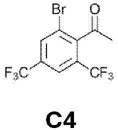

n-BuLi (6.83 mL, 2.5 M in hexanes, 17 mmol) was added dropwise to a solution of 2,2,6,6-tetramethylpiperidine (2.41 g, 17.1 mmol) in anhydrous THF (40 mL) at -78 °C. 1-Bromo-3,5-bis(trifluoromethyl)benzene was added dropwise after 15 minutes at the same temperature. Stirring was continued for one hour. Subsequently, the reaction mixture was transferred via cannula to a mixture of acetic anhydride (16 mL, 171 mmol) and THF (16 mL) at -78 °C. The resulting mixture was slowly warmed to room temperature. The resulting homogenous solution was poured into a saturated aqueous solution of Na₂CO₃ (200 mL) and solid Na₂CO₃was added until gas formation ceased. The resulting mixture was extracted with MTBE (2 x 100 mL). The combined organic phases were dried over MgSO₄, and the solvents were evaporated. Purification of the crude reaction product was purified by column chromatography over silica (PE/MTBE = 40:1 to 20:1) to yield acetophenone **C4** (1.74 g, 30%) as a colourless liquid.

APCI-MS: m/z = 334.6 [M-⁷⁹Br+H]⁺; 336.6 [M-⁸¹Br+H]⁺.

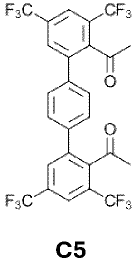

A mixture of benzene-1,4-diboronic acid (200 mg, 1.21 mmol), acetophenone **C4** (930 mg, 2.78 mmol) and potassium carbonate (834 mg, 6.03 mmol) in toluene (6 mL) and ethanol (3 mL) was flushed with nitrogen for 10 minutes. Tetrakis(triphenylphosphin)palladium(0) (139 mg, 0.12 mmol) was added and the resulting mixture was heated to 80 °C under nitrogen for 17 hours. Subsequently, the suspension was cooled to room temperature, water (50 mL) was added, and the aqueous phase was extracted with CH₂Cl₂ (3 x 30 mL). The combined organic phases were dried over Na₂SO₄. After evaporation of solvents the crude product was purified by column chromatography over silica (PE/EA = 20:1 to 9:1) yielding bisacetophenone **C5** (490 mg, 69%) as a white solid.

APCI-MS: m/z = 585.5 [M]⁺.

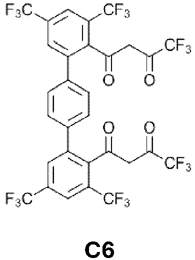

Sodium methoxide (22.1 mg, 0.41 mmol) was added in one portion to a solution of ethyl trifluoroacetate (227 mg, 1.60 mmol) in MTBE (3 mL) at room temperature. After the resulting suspension was stirred for 5 minutes, bisacetophenone **C5** (100 mg, 0.17 mmol) was added. After 17 hours 3 M aqueous HCl (10 mL) was added. The phases were separated, and the aqueous phase was extracted with CH₂Cl₂ (3 x 10 mL). The combined organic phases were dried over Na₂SO₄ and the solvents were removed under reduced pressure. The product was dried under vacuum yielding tetraketone **C6** (121 mg, 91 %) as an off-white solid.

APCI-MS: m/z = 778.9 [M+H]⁺.

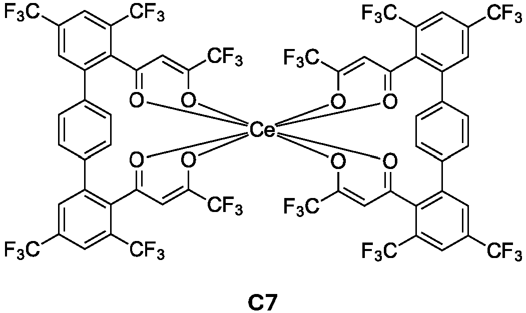

Sodium hydride (12.3 mg, 60% dispersion in mineral oil, 308 µmol) was added in one portion to a solution of tetraketone **C6** (120 mg, 154 µmol) in acetonitrile (4 mL). The resulting mixture was stirred for ten minutes until gas evolution ceased. Subsequently, ceric ammonium nitrate (42.3 mg, 77 µmol) was added in one portion and the resulting mixture was stirred for 30 minutes. The reaction mixture was filtered, and the precipitate was washed with water (10 mL). Drying under vacuum afforded cerium complex **C7** (83 mg, 64%) as a brown solid.

APCI-MS: m/z = 1710.0 [M+H]⁺.

### SYNTHESIS OF COMPLEX C11

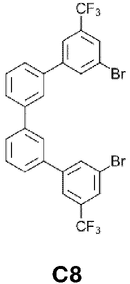

A mixture of 3,3'-Bis(4,4,5,5-tetramethyl-1,3,2-dioxaborolan-2-yl)-1,1'-biphenyl (1.00 g, 2.85 mmol), potassium fluoride (828 mg, 14.2 mmol) in DMF (20 mL) and water (1 mL) was flushed with nitrogen for 10 minutes. Subsequently, 1-bromo-3-iodo-5-(trifluoromethyl)benzene (3.47 g, 8.55 mmol) and [1,1'-bis(diphenylphosphino)ferrocene]dichlorpalladium(II) (209 mg, 0.29 mmol) were added and the resulting mixture was heated to 80 °C under nitrogen. After 17 hours the suspension was cooled to rt, water (200 mL) was added, and the resulting mixture was extracted with MTBE (3 x 50 mL). The combined organic phases were washed with brine (50 mL) and dried over MgSO₄. After evaporation of solvents the crude product was purified by column chromatography over silica (PE to PE/ CH₂Cl₂ = 10:1) yielding dibromide **C8** (1.12 g, 65%) as a white solid.

APCI-MS: m/z = 597.3 [M-⁷⁹Br⁷⁹Br]⁺; 599.3 [M-⁷⁹Br⁸¹Br]⁺; 601.2 [M-⁸¹Br⁸¹Br]⁺.

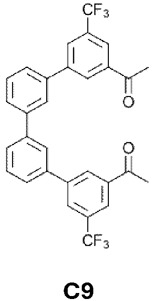

Dibromide **C8** (1.06 g, 1.77 mmol), butyl vinyl ether (1.06 g, 10.6 mmol), palladium(II) acetate (31.7 mg, 0.14 mmol), 1,3-bis(diphenylphosphino)propane (87.4 mg, 0.21 mmol) and triethylamine (894 mg, 8.83 mmol) were dissolved in isopropanol (3.5 mL) in a microwave vial. Argon was bubbled through the resulting solution for 5 minutes and the vial was sealed. The reaction mixture was heated to 115 °C for 21 hours. After cooling the mixture to room temperature, 3 M aqueous HCl (30 mL) was added and stirring was continued for 30 minutes. The formed precipitate was filtered and purified by column chromatography over silica (PE/DCM = 8:2 to 6:4) yielding bisacetophenone **C9** (807 mg, 87%) as a white solid.

APCI-MS: m/z = 525.6 [M]⁺.

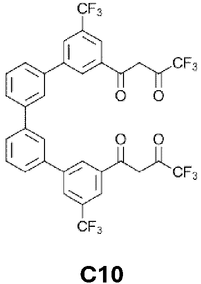

Sodium methoxide (86.2 mg, 1.60 mmol) was added in one portion to a solution of ethyl trifluoroacetate (227 mg, 1.60 mmol) in MTBE (5 mL) at room temperature. After the resulting suspension was stirred for 10 minutes, bisacetophenone **C9** (350 mg, 0.67 mmol) was added. After 17 hours 3 M aqueous HCl (20 mL) was added. The phases were separated, and the aqueous phase was extracted with CH₂Cl₂ (3 x 10 mL). The combined organic phases were dried over Na₂SO₄ and the solvents were removed under reduced pressure. The product was dried under vacuum yielding tetraketone **C10** (466 mg, 98%) as an off-white solid.

APCI-MS: m/z = 718.1 [M]⁺.

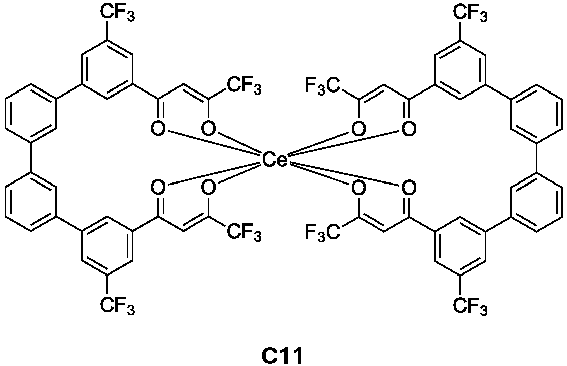

Sodium hydride (11.1 mg, 60% dispersion in mineral oil, 278 µmol) was added in one portion to a solution of tetraketone **C10** (100 mg, 139 µmol) in 1,2-dimethoxyethane (2 mL). The resulting mixture was stirred for ten minutes until gas evolution ceased. Subsequently, ceric ammonium nitrate (38.2 mg, 70 µmol) was added in one portion and the resulting mixture was stirred for 30 minutes. The solvent was evaporated and resulting solid was washed with water (10 mL) and CH₂Cl₂ (10 mL). The product was dried under vacuum yielding cerium complex **C11** (54 mg, 49%) as a red-brown solid.

APCI-MS: m/z = 1571.9 [M+H]⁺.

### SYNTHESIS OF COMPLEX C13

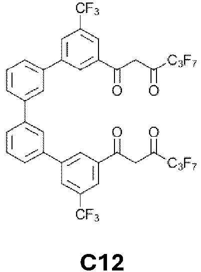

Sodium methoxide (91.5 mg, 1.69 mmol) was added in one portion to a solution of ethyl heptafluorobutanoate (410 mg, 1.69 mmol) in MTBE (10 mL) at room temperature. After the resulting suspension was stirred for 10 minutes, bisacetophenone **C9** (371 mg, 0.71 mmol) was added. After 2 days 3 M aqueous HCl (30 mL) was added. The phases were separated, and the aqueous phase was extracted with MTBE (2 x 20 mL). The combined organic phases were dried over MgSO₄ and the solvent was removed under reduced pressure. The product was dried under vacuum yielding tetraketone **C12** (636 mg, 98%) as an off-white solid.

APCI-MS: m/z = 918.3 [M]⁺.

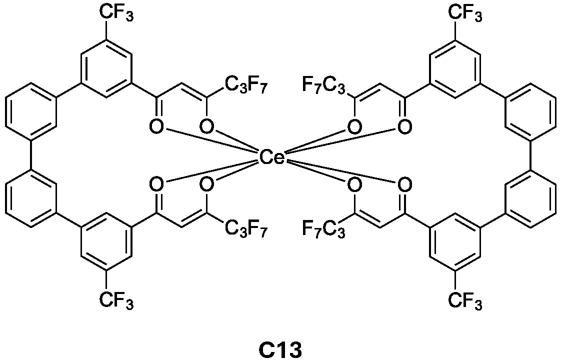

Sodium hydride (26.1 mg, 60% dispersion in mineral oil, 653 µmol) was added in one portion to a solution of tetraketone **C12** (300 mg, 327 µmol) in 1,2-dimethoxyethane (6 mL). The resulting mixture was stirred for ten minutes until gas evolution ceased. Subsequently, ceric ammonium nitrate (89.5 mg, 163 µmol) was added in one portion and the resulting mixture was stirred for 30 minutes. The solvent was evaporated, and the resulting solid was washed with water (10 mL) and CH₂Cb (10 mL). The product was dried under vacuum yielding cerium complex **C13** (274 mg, 85%) as a red-brown solid.

APCI-MS: m/z = 1972.5 [M]⁺.

### SYNTHESIS OF COMPLEX C18

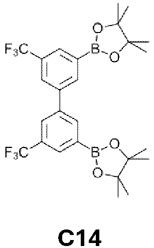

A mixture of bis(pinacolato)diboron (5.25 g, 20.7 mmol) and 4,4'-di-*tert*-butyl-2,2'-dipyridyl (92.5 mg, 345 µmol) in *n*-heptane (50 mL) was flushed with nitrogen for 10 min. Subsequently, 3,3'-bis(trifluoromethyl)-1,1'-biphenyl (5.00 g, 17.2 mmol) and bis(1,5-cyclooctadiene)di-µ-methoxydiiridium(I) (114 mg, 172 µmol) were added. The resulting mixture was heated to 70 °C for 22 hours. The solvent was evaporated after cooling the rection mixture to room temperature. The crude product was washed with methanol and dried under vacuum affording bisboronic ester **C14** (8.45 g, 90%) as an off-white solid.

APCI-MS: m/z = 542.6 [M]⁺

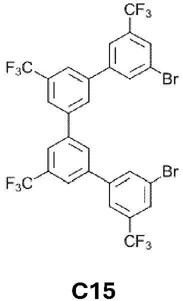

A mixture of bisboronic ester **C14** (1.00 g, 1.84 mmol), potassium fluoride (643 mg, 11.1 mmol) in DMF (10 mL) and water (0.5 mL) was flushed with nitrogen for 10 minutes. Subsequently, 1-bromo-3-iodo-5-(trifluoromethyl)benzene (1.94 g, 5.53 mmol) and [1,1'-bis(diphenylphosphino) ferrocene]dichlorpalladium(II) (135 mg, 0.18 mmol) were added and the resulting mixture was heated to 80 °C under nitrogen. After 22 hours the suspension was cooled to rt, water (200 mL) was added, and the resulting mixture was extracted with MTBE (3 x 50 mL). The combined organic phases were washed with 3 M aqueous HCl (50 mL) and dried over MgSO₄. After evaporation of solvents the crude product was purified by column chromatography over silica (PE) yielding dibromide **C15** (1.07 g, 79%) as a white solid.

APCI-MS: m/z = 733.1 [M-⁷⁹Br⁷⁹Br]⁺; 735.0 [M-⁷⁹Br⁸¹Br]⁺; 737.1 [M-⁸¹Br⁸¹Br]⁺.

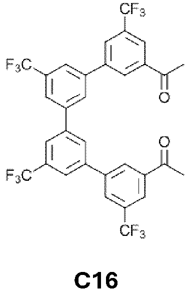

Dibromide **C15** (1.00 g, 1.36 mmol), butyl vinyl ether (816 mg, 8.15 mmol), palladium(II) acetate (24.4 mg, 0.11 mmol), 1,3-bis(diphenylphosphino)propane (67.2 mg, 0.16 mmol) and triethylamine (687 mg, 6.79 mmol) were dissolved in isopropanol (4.5 mL) in a microwave vial. Argon was bubbled through the resulting solution for 5 minutes and the vial was sealed. The reaction mixture was heated to 115 °C for 19 hours. After cooling the mixture to room temperature, 3 M aqueous HCl (15 mL) was added and stirring was continued for 30 minutes. The resulting mixture was extracted with CH₂Cl₂(3 x 15 mL) and the combined organic phases were dried over MgSO₄. The solvents were evaporated, and the crude product was filtered over silica (PE/MTBE = 10:1 to 7:3). Additionally, the resulting white solid was recrystallized from a mixture of n-hexane, MTBE and dichlorethane (10 mL, 7:2:1) yielding bisacetophenone **C16** (500 mg, 70%) as colorless crystals.

APCI-MS: m/z = 662.1 [M+H]⁺.

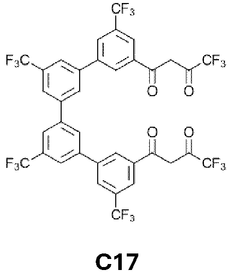

Sodium methoxide (49.2 mg, 910 µmol) was added in one portion to a solution of ethyl trifluoroacetate (129 mg, 910 µmol) in MTBE (5 mL) at room temperature. After the resulting suspension was stirred for 10 minutes, bisacetophenone **C16** (251 mg, 379 µmol) was added. After 18 hours 3 M aqueous HCl (20 mL) was added. The resulting mixture was extracted with MTBE (3 x 10 mL). The combined organic phases were dried over Na₂SO₄, and the solvent was removed under reduced pressure. The product was dried under vacuum yielding tetraketone **C17** (324 mg, 100%) as an off-white solid.

APCI-MS: m/z = 853.9 [M]⁺.

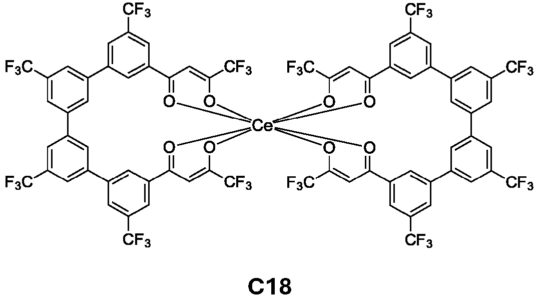

Sodium hydride (30.4 mg, 60% dispersion in mineral oil, 760 µmol) was added in one portion to a solution of tetraketone **C17** (300 mg, 327 µmol) in 1,2-dimethoxyethane (6 mL). The resulting mixture was stirred for ten minutes until gas evolution ceased. Subsequently, ceric ammonium nitrate (89.5 mg, 163 µmol) was added in one portion and the resulting mixture was stirred for 30 minutes. The solvent was evaporated, and the resulting solid was washed with water (10 mL) and CH₂Cb (10 mL). The product was dried under vacuum yielding cerium complex **C18** (274 mg, 85%) as a red-brown solid.

APCI-MS: m/z = 1844.3 [M]⁺.

### SYNTHESIS OF COMPLEX C20

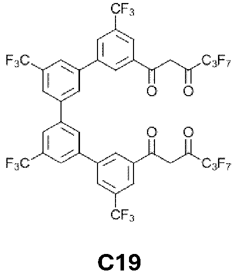

Sodium methoxide (47.7 mg, 883 µmol) was added in one portion to a solution of ethyl heptafluorobutanoate (214 mg, 883 µmol) in MTBE (5 mL) at room temperature. After the resulting suspension was stirred for 5 minutes, bisacetophenone **C16** (243.8 mg, 368 µmol) was added. After 18 hours 3 M aqueous HCl (10 mL) was added. The phases were separated, and the aqueous phase was extracted with MTBE (2 x 10 mL). The combined organic phases were dried over MgSO₄, and the solvent was removed under reduced pressure. The product was dried under vacuum yielding tetraketone **C19** (388 mg, 100%) as a white solid.

APCI-MS: m/z = 1053.7 [M]⁺.

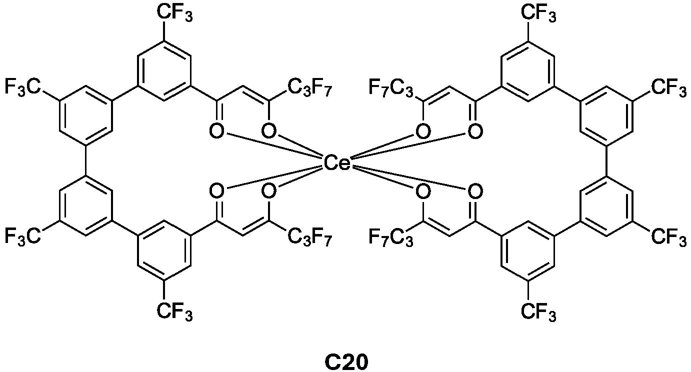

Sodium hydride (30.6 mg, 60% dispersion in mineral oil, 760 µmol) was added in one portion to a solution of tetraketone **C19** (300 mg, 327 µmol) in 1,2-dimethoxyethane (6 mL). The resulting mixture was stirred for ten minutes until gas evolution ceased. Subsequently, ceric ammonium nitrate (89.5 mg, 163 µmol) was added in one portion and the resulting mixture was stirred for 30 minutes. The solvent was evaporated, and the resulting solid was washed with water (10 mL) and CH₂Cb (10 mL). The product was dried under vacuum yielding cerium complex **C20** (274 mg, 85%) as a red-brown solid.

### SYNTHESIS OF COMPLEX C24

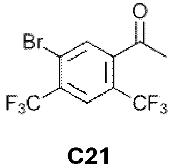

A solution of isopropyl magnesium chloride (10.1 mL, 2.5 M in THF, 20.2 mmol) was added dropwise to a solution of 1,5-dibromo-2,4-bis(trifluoromethyl)benzene (5.00 g, 13.4 mmol) in THF (10 mL) at 0 °C. The resulting solution was added to acetic anhydride (13.73 mmol, 134 mmol) dropwise via syringe after at 0°C after 30 minutes. The resulting mixture was stirred for 30 minutes at the same temperature, warmed to room temperature and stirred for additional 1.5 hours. Subsequently, a saturated aqueous NaHCO₃ solution (300 mL) was added and solid Na₂CO₃ was added until gas formation ceased. The resulting mixture was extracted with MTBE (2 x 100 mL) and the combined organic phases were dried over Na₂SO₄. Evaporation of solvents and filtration over silica (PE/MTBE = 10:1) yielded acetophenone **C21** (4.137 g, 76%) as a colorless oil.

APCI-MS: m/z = 334.6 [M-⁷⁹Br+H]⁺; 336.6 [M-⁸¹Br+H]⁺.

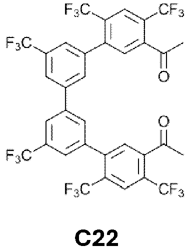

A mixture of bisboronic ester **C14** (1.00 g, 1.84 mmol), acetophenone **C21** (1.85 g, 5.53 mmol), palladium(II) acetate (20.7 mg, 0.092 mmol), dicyclohexyl(2',6'-dimethoxy[1,1'-biphenyl]-2-yl)phosphane (75.7 mg, 0.184 mmol) and potassium fluoride (536 mg, 9.22 mmol) in DMF (10 mL) and water (0.5 mL) was flushed with nitrogen for 10 minutes. The resulting mixture was heated to 80 °C for 16 hours. Subsequently, it was cooled to room temperature and water was added. The resulting mixture was extracted with DCM (3 x 50 mL). The combined organic phases were washed with water (2 x 30 mL) and brine (20 mL) and dried over Na₂SO₄. Evaporation of solvents and column chromatography over silica (PE/MTBE = 20:1 to 10:1) yielded bisacetophenone **C22** (939 mg, 64%) as white solid.

APCI-MS: m/z = 797.6 [M]⁺.

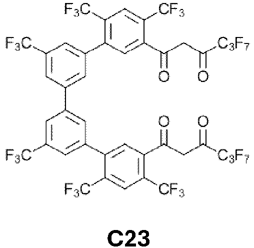

Sodium methoxide (48.7 mg, 902 µmol) was added in one portion to a solution of ethyl heptafluorobutanoate (218 mg, 902 µmol) in MTBE (4 mL) at room temperature. After the resulting mixture was stirred for 5 minutes, bisacetophenone **C22** (300 mg, 376 µmol) was added. After 19 hours 3 M aqueous HCl (10 mL) was added. The phases were separated, and the aqueous phase was extracted with MTBE (2 x 10 mL). The combined organic phases were dried over Na₂SO₄, and the solvent was removed under reduced pressure. The product was dried under vacuum yielding tetraketone **C23** (447 mg, 100%) as an off-white solid.

APCI-MS: m/z = 1188.6 [M]⁺.

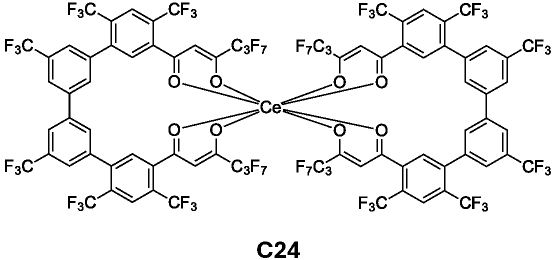

Sodium hydride (29.4 mg, 60% dispersion in mineral oil, 735 µmol) was added in one portion to a solution of tetraketone **C23** (437.4 mg, 367 µmol) in acetonitrile (10 mL). The resulting mixture was stirred for 15 minutes until gas evolution ceased. Subsequently, ceric ammonium nitrate (96.7 mg, 176 µmol) was added in one portion and the resulting mixture was stirred for 30 minutes. The solvent was evaporated, and the resulting solid was washed with water (20 mL) and CH₂Cl₂(20 mL). The product was dried under vacuum yielding cerium complex **C24** (361 mg, 78%) as a red-brown solid.

¹H-NMR (80 MHz, CDCl₃, 298 K): δ (in ppm) = 8.01 - 7.87 (m, 2H), 7.79 - 7.58 (m, 4H).

¹⁹F-NMR (76 MHz, CDCl₃, 298 K): δ (in ppm) = -125.20, -118.27, -80.21, -61.92, -56.71.

### SYNTHESIS OF COMPLEX C30

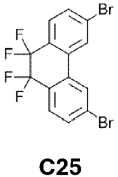

Triethylamine trihydrofluoride (6.8 mL, 41.0 mmol) was added to a suspension of 3,6-dibromo-9,10-phenanthrenedione (5.00 g, 13.7 mmol) and diethylaminodifluorosulfinium tetrafluoro-borate (9.39 g, 41.0 mmol) in 1,2-dichloroethane (50 mL) in a pressure tube. The reaction mixture was heated to 90 °C for 3 days after sealing the pressure tube. Subsequently, the mixture was cooled to room temperature, saturated aqueous NaHCO₃ (200 mL) was added, and the resulting mixture was stirred for 10 min. Water (100 mL) and CH₂Cl₂ (200 mL) were added. Phases were separated and the aqueous phase was extracted with DCM (2 x 100 mL). The combined organic phases were dried over MgSO₄, and solvents were evaporated. Filtration over silica (PE) yielded dibromide **C25** (3.78 g, 67%) as a white solid.

¹H-NMR (80 MHz, CDCl₃, 298 K): δ (in ppm) = 8.01 - 7.87 (m, 2H), 7.79 - 7.58 (m, 4H).

¹⁹F-NMR (76 MHz, CDCl₃, 298 K): δ (in ppm) = -119.37.

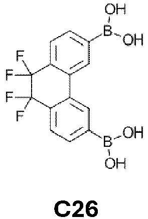

A solution of n-butyllithium (2.2 mL, 2.5 M in hexanes, 5.5 mmol) was added dropwise to a solution of dibromide **C25** (1.02 g, 2.5 mmol) in diethyl ether (10 mL) at -78 °C. The resulting mixture was stirred at the same temperature for 1.5 hours. Trimethyl borate was added dropwise, and the resulting mixture was slowly warmed to room temperature. Stirring was continued for one hour before 3 M aqueous HCl (50 mL) was added. The resulting biphasic mixture was stirred for another two hours. Subsequently, the mixture was extracted with ethyl acetate (3 x 30 mL). The combined organic phases were dried over MgSO₄, and solvents were evaporated. The resulting white solid was washed with water (50 mL) and chloroform (50 mL). Drying under vacuum yielded bisboronic acid **C26** (594 mg, 70%) as a white solid.

¹H-NMR (80 MHz, D₃COD, 298 K): δ (in ppm) = 8.43 - 8.20 (m, 2H), 7.90 - 7.68 (m, 4H), 4.83 (br.s. 4H).

¹⁹F-NMR (76 MHz, D₃COD, 298 K): δ (in ppm) = -121.52.

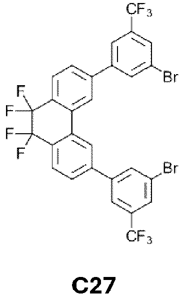

A mixture of bisboronic acid **C26** (570 mg, 1.63 mmol), potassium fluoride (585 mg, 10.1 mmol) and [1,1'-bis(diphenylphosphino) ferrocene]dichlorpalladium(II) (123 mg, 0.168 mmol) in DMF (10 mL) and water (0.5 mL) was flushed with nitrogen for 10 minutes. Subsequently, 1-bromo-3-iodo-5-(trifluoromethyl)benzene (1.77 g, 5.03 mmol) was added and the resulting mixture was heated to 80 °C under nitrogen. After 19 hours the suspension was cooled to rt, water (200 mL) was added and the resulting mixture was extracted with DCM (3 x 50 mL). The combined organic phases were dried over MgSO₄. After evaporation of solvents the crude product was purified by column chromatography over silica (PE to PE/MTBE = 40:1) yielding dibromide **C27** (708 mg, 60%) as a white solid.

APCI-MS: m/z = 694.9 [M-⁷⁹Br⁷⁹Br]⁺; 696.7 [M-⁷⁹Br⁸¹Br]⁺; 698.0 [M-⁸¹Br⁸¹Br]⁺.

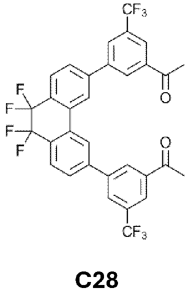

Dibromide **C27** (700 mg, 1.00 mmol), butyl vinyl ether (603 mg, 6.02 mmol), palladium(II) acetate (18 mg, 0.08 mmol), 1,3-bis(diphenylphosphino)propane (49.6 mg, 0.12mmol) and triethylamine (507 mg, 5.0 mmol) were dissolved in isopropanol (5 mL) in a microwave vial. Nitrogen was bubbled through the resulting solution for 10 minutes and the vial was sealed. The reaction mixture was heated to 115 °C for 18 hours. After cooling the mixture to room temperature, 3 M aqueous HCl (15 mL) was added and stirring was continued for 90 minutes. The resulting mixture was extracted with MTBE (3 x 20 mL) and the combined organic phases were dried over Na₂SO₄. The solvents were evaporated, and the crude product was filtered over silica (PE/MTBE = 8:2 to 7:3 yielding bisacetophenone **C28** (415.7 mg, 66%) as a white solid.

APCI-MS: m/z = 624.3 [M]⁺.

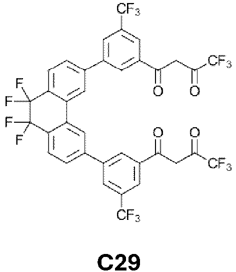

Sodium methoxide (62.3 mg, 1.15 mmol) was added in one portion to a solution of ethyl trifluoroacetate (165 mg, 1.15 mmol) in MTBE (5 mL) at room temperature. After the resulting suspension was stirred for 5 minutes, bisacetophenone **C28** (300 mg, 480 µmol) was added. After 20 hours, 3 M aqueous HCl (20 mL) was added. The resulting mixture was extracted with MTBE (2 x 20 mL). The combined organic phases were dried over Na₂SO₄, and the solvent was removed under reduced pressure. The product was dried under vacuum yielding tetraketone **C29** (365 mg, 93%) as an off-white solid.

APCI-MS: m/z = 816.0 [M]⁺.

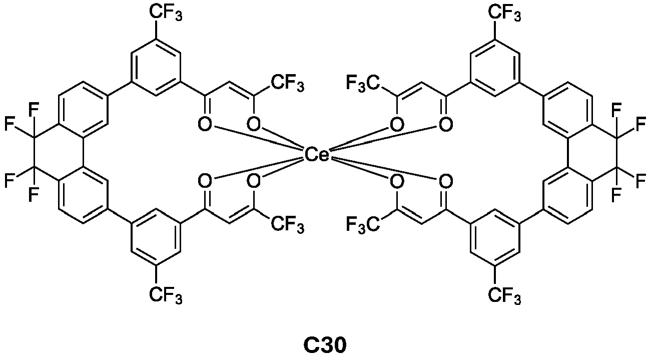

Sodium hydride (35.4 mg, 60% dispersion in mineral oil, 885 µmol) was added in one portion to a solution of tetraketone **C29**(361.1 mg, 442 µmol) in 1,2-dimethoxyethane (6 mL). The resulting mixture was stirred for ten minutes until gas evolution ceased. Subsequently, ceric ammonium nitrate (112 mg, 212 µmol) was added in one portion and the resulting mixture was stirred for 30 minutes. The solvent was evaporated and the resulting solid was washed with water (20 mL). The product was dried under vacuum yielding cerium complex **C30** (314.7 mg, 80%) as a red-brown solid.

APCI-MS: m/z = 1768.5 [M]⁺.

### SYNTHESIS OF COMPLEX C33

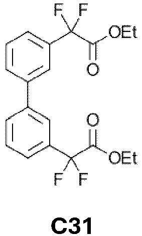

A solution of dibromobis(triphenylphosphine)nickel(II) (2.47 g, 3.32 mmol) and tetra-n-butylammonium iodide (6.13 g, 16.6 mmol) in THF (40 mL) was flushed with argon for 5 minutes. Subsequently, zinc powder (3.26 g, 49.8 mmol) was added and the resulting mixture was stirred for 30 minutes, when a dark red suspension was obtained. A degassed solution of ethyl 2-(3-bromophenyl)-2,2-difluoroacetate (9.27 g, 33.2 mmol) in THF (15 mL) was added and the resulting mixture was heated to 50 °C for 19 hours. Subsequently, the reaction mixture was cooled to room temperature, diluted with CH₂Cl₂, and filtered. The solvents were removed under reduced pressure and the crude product was filtered over silica (PE/CH₂Cl₂ = 9:1 to PE/EA = 9:1) yielding diester **C31** (5.20 g, 79%) as colourless liquid.

APCI-MS: m/z = 397.6 [M]⁺.

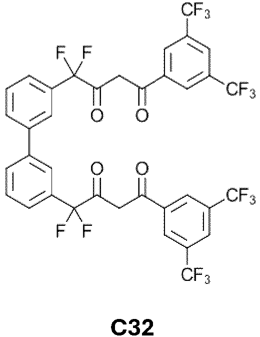

Sodium methoxide (160 mg, 3.01 mmol) was added in one portion to a solution of diester **C31** (500 mg, 1.26 mmol) in THF (10 mL) at 0 °C and the resulting mixture was stirred for 10 minutes. 1-(3,5-Bis(trifluoromethyl)phenyl)ethenone (766 mg, 3.01 mmol) was added. The reaction mixture was poured into a mixture of ice and a saturated aqueous solution of NH₄Cl after 25 minutes. The solution was decanted and the precipitate was washed with water. Subsequently, PE was added and the resulting suspension was stirred for 15 minutes, before the precipitate was collected by filtration. Drying under vacuum yielded tetraketone **C32** (96.5 mg, 9%) as a white solid.

APCI-MS: m/z = 819.1 [M+H]⁺.

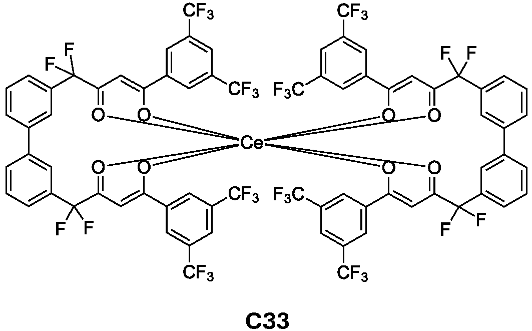

Sodium hydride (38.8 mg, 60% dispersion in mineral oil, 969 µmol) was added in one portion to a solution of tetraketone **C32** (396.7 mg, 485 µmol) in 1,2-dimethoxyethane (10 mL). The resulting mixture was stirred for ten minutes until gas evolution ceased. Subsequently, ceric ammonium nitrate (133 mg, 242 µmol) was added in one portion and the resulting mixture was stirred for 40 minutes. The resulting mixture was filtered and the filtrate concentrated under reduced pressure. The resulting solid was washed with water (50 mL) and DCM (50 mL). The product was dried under vacuum yielding cerium complex **C33** (298.7 mg, 70%) as a red-brown solid.

APCI-MS: m/z = 1772.2 [M]⁺.

### SYNTHESIS OF COMPLEX C36

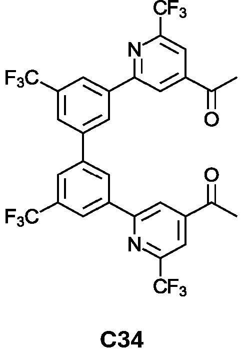

A mixture of bisboronic ester **C14** (4.78 g, 8.82 mmol), potassium fluoride (3.07mg, 52.9 mmol) in DMF (50 mL) and water (2.5 mL) was flushed with nitrogen for 10 minutes. Subsequently, 1-[2-chloro-6-(trifluoromethyl)-4-pyridinyl]ethanone (4.93 g, 22.0 mmol) and [1,1'-bis(diphenyl-phosphino)ferrocene]dichlorpalladium(II) (452 mg, 0.62 mmol) were added and the resulting mixture was heated to 80 °C under nitrogen. After 24 hours the suspension was cooled to rt, water (500 mL) was added, and the resulting mixture was extracted with DCM (3 x 100 mL). The combined organic phases were over MgSO₄. After evaporation of solvents the crude product was purified recrystallization (1,2-dichloroethane/EtOAc =1:1) yielding bisacetophenone **C34** (2.29 g, 39%) as a white solid.

APCI-MS: m/z = 664.2 [M]⁺.

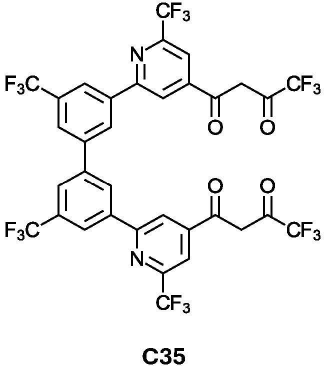

Sodium methoxide (78.1 mg, 1.44 mmol) was added in one portion to a solution of ethyl trifluoroacetate (205 mg, 1.44 mmol) in MTBE (5 mL) at room temperature. After the resulting suspension was stirred for 5 minutes, bisacetophenone **C34** (400 mg, 602 µmol) was added. After 3 hours 3 M aqueous HCl (20 mL) was added. The resulting mixture was extracted with EA (3 x 10 mL). The combined organic phases were dried over Na₂SO₄, and the solvent was removed under reduced pressure. The product was dried under vacuum yielding tetraketone **C35** (359 mg, 70%) as an off-white solid.

APCI-MS: m/z = 856.0 [M]⁺.

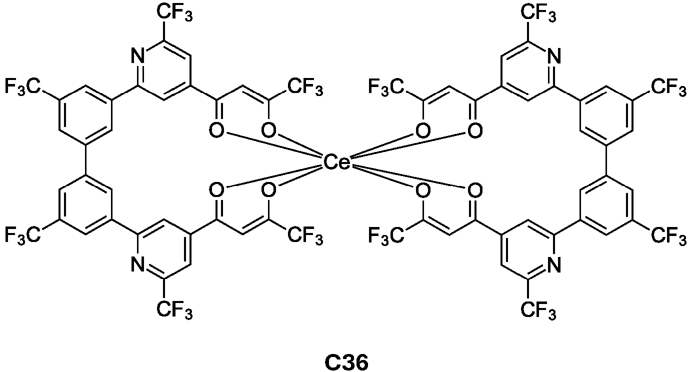

Sodium hydride (28.2 mg, 60% dispersion in mineral oil, 705 µmol) was added in one portion to a solution of tetraketone **C35** (302 mg, 353 µmol) in 1,2-dimethoxyethane (5 mL). The resulting mixture was stirred for ten minutes until gas evolution ceased. Subsequently, ceric ammonium nitrate (96.7 mg, 176 µmol) was added in one portion and the resulting mixture was stirred for 30 minutes. The solvent was evaporated, and the resulting solid was washed with water (10 mL), hexanes (10 mL) and CH₂Cl₂ (10 mL). The product was dried under vacuum yielding cerium complex **C36** (295 mg, 90%) as a red-brown solid.

APCI-MS: m/z = 1847.7 [M]⁺.

### SAMPLE PREPARATION, ABSORPTION AND CONDUCTIVITY MEASUREMENT

To determine the evaporation temperature, 15 mg of the material was filled in an aluminum oxide crucible of a point source and heated in a vacuum chamber (base pressure <5 × 10 ⁻⁷ mbar) at 5 K/min until an evaporation rate of 0.3 Å/s is reached. The evaporation rate is monitored with a quartz crystal microbalance (QCM). The rate is kept constant for 10 min by controlling the heating and the evaporation temperature is determined by measuring the temperature at the bottom of the crucible with a thermocouple. To achieve stable evaporation rates and to avoid cross contamination in mass production of organic electronic devices, such as OLEDs, it is advantageous to use materials with a high evaporation temperature of at least above 120°C. Advantageously, evaporation temperatures above 120°C reduce the risk of cross contamination during thermal evaporation in vacuum and are accordingly suitable for mass production.

For the measurement of the lateral conductivity, a transmission line method was used. Interdigitated ITO (indium tin oxide) electrodes were formed by photolithography on a glass substrate with four different channel lengths (40 µm, 80 µm, 120 µm, 160 µm). Then organic layers were deposited by thermal evaporation under ultrahigh vacuum conditions (base pressure <5 × 10 ⁻⁷ mbar) by controlling the evaporation rates with quartz crystal microbalances (QCMs). A 10 nm thick p-doped layer was prepared by co-evaporation of the p-dopant and the semiconductor matrix material. To obtain a specific dopant concentration, the individual deposition rates were controlled with independent QCMs. Current-voltage characteristics (-10 V to 10 V) were measured in-situ using a source-measure unit Keithley 2400 and the lateral conductivity was determined from the slope of the resistance vs. channel length plot and by normalizing to the thickness of the p-doped layer.

As semiconductor matrix material, HT-1 (N-([1,1'-Biphenyl]-4-yl)-9,9-dimethyl-N-(4-(9-phenyl-9H-carbazol-3-yl)phenyl)-9H-fluoren-2-amine), HT-2 (N-(9,9-Diphenyl-9H-fluoren-2-yl)-N,9-diphenyl-9H-carbazol-3-amine), and HT-3 (9,9-bis[4-(N,N-bis-biphenyl-4-yl-amino)phenyl]-9H-fluorene) were used. HT-1, HT-2, and HT-3 have a HOMO level of about -5.15 eV, -5.08 eV, and -5.28 eV, respectively, wherein the HOMO level is measured by cyclic voltammetry as described herein.

The HOMO level was determined by cyclic voltammetry measured with a platinum working and counter electrode, an Ag/AgCl reference electrode and Ferrocene/Ferrocenium as an internal standard and a scan rate of 0.1V/s. As electrolyte, acetonitrile with 0.1M tetrabutylammonium hexafluorophosphate was used. The HOMO level was calculated from E(HOMO) = -4.79 eV - E_{1/2}(oxidation vs. Fc/Fc+).

The absorption spectra of the materials were measured using a SolidSpec-3700 spectrophotometer (Shimadzu Corp.). For this measurement, 30 nm of the organic material was deposited onto a quartz glass substrate by thermal evaporation under ultrahigh vacuum conditions with a base pressure < 5 × 10⁻⁷ mbar. The sample was then placed into the spectrometer, where reflectance and transmittance were recorded over a range of wavelengths. The absorption is then calculated as a remainder, by subtracting the measured reflectance and transmittance from unity.

### TECHNICAL EFFECT

**Table 8:**

| p-Dopant | T_evap |
|---|---|
| C3 | 174°C |
| C20 | 202°C |

**Table 9:**

| p-Dopant | HTM (hole transport material) | Dopant concentration (wt%) | Conductivity in 1E-5 S/cm |
|---|---|---|---|
| None | HT-1 | 0 | <0.001 |
| F6-TCNNQ | HT-1 | 10 | 0.5 |
| C3 | HT-1 | 10 | 2.0 |
| C20 | HT-1 | 10 | 12.4 |
| None | HT-2 | 0 | <0.001 |
| F6-TCNNQ | HT-2 | 10 | 0.1 |
| C3 | HT-2 | 10 | 2.1 |
| C20 | HT-2 | 10 | 3.5 |
| None | HT-3 | 0 | <0.001 |
| F6-TCNNQ | HT-3 | 10 | 0.2 |
| C20 | HT-3 | 10 | 0.7 |

A technical effect is shown in Table 8. As can be seen from Table 8, Inventive examples C3 and C20 show high evaporation temperatures, significantly above 120°C. Accordingly, these materials can advantageously be used for mass production using thermal evaporation. To achieve stable evaporation rates and to avoid cross contamination in mass production of organic electronic devices, such as OLEDs, it is advantageous to use materials with a high evaporation temperature of at least above 120°C, preferably above 150°C. Advantageously, evaporation temperatures above 120°C reduce the risk of cross contamination during thermal evaporation in vacuum and are accordingly suitable for mass production.

Another technical effect is shown in Table 9, which shows that inventive examples C3 and C20 lead to conductivities above 1E-5 S/cm for semiconductor matrix materials with shallow HOMO, such as HT-1 and HT-2, and should therefore be suitable for use in organic electronic devices such as OLEDs and organic solar cells. Inventive example C20 leads to conductivities well above 1E-6 S/cm even for semiconductor matrix materials with deeper HOMO, such as HT-3.

Especially the possibility of doping matrix materials with deep HOMOs is a critical aspect in order to further improve the efficiency of organic electronic components. In organic solar cells, the application of doped semiconductors with a deep HOMO level may increase the achievable built-in voltage and may accordingly improve the power conversion efficiency. In OLEDs, the use of doped semiconductors with a deep HOMO in the hole injection or hole transport layer enables the use of new more efficient materials in the emitting layer while maintaining a low operating voltage and long lifetime. These new materials for the emitting layer include blue phosphorescent emitters and blue emitters showing thermally activated delayed fluorescence. Therefore, it is highly relevant to improve the doping of matrix materials with deep HOMO levels or deep HOMO energies.

To verify that the inventive examples are suitable for use in OLEDs, an OLED structure was prepared as follows. For Example 1 (E1), a glass substrate with pre-patterned 130 nm ITO anode was ultrasonically washed with dimethyl sulfoxide for 20 minutes, rinsed by Di-water for 5 minutes and ultrasonically washed with first Di-water and then with ethanol for 10 minutes. The substrate was then rinsed with Di-water and consequently dry-spined at 1500 rpm in a nitrogen stream, followed by oxygen plasma treatment to prepare the anode surface.

Then, 10 nm of HT-1 (9H-Fluoren-2-amine, N-[1,1'-biphenyl]-4-yl-9,9-dimethyl-N-[4-(9-phenyl-9H-carbazol-3-yl)phenyl]) doped with 3 vol% of C3 was vacuum deposited to form a hole-injection layer (HIL). Then, HT-1 was vacuum deposited on top of HIL to form hole transport layer (HTL) with a thickness of 100 nm. Then, an electron-blocking layer (EBL) was formed on the HTL by depositing 4-[Bis(1,1'-biphenyl-4-yl)amino]-4'-(9H-carbazol-9-yl)-1,1'-biphenyl with a thickness of 10 nm.

Then, a blue-emitting emission layer (EML) consisting of 97 vol% 2-Methyl-9,10-di-2-naphthalenylanthracene (MADN) as EML host and 3 vol% 4,4'-([1,1'-Biphenyl]-4,4'-diyldi-2,1-ethenediyl)bis[N,N-bis(4-methylphenyl)benzenamine (DPAVBi ) as fluorescent blue emitter dopant was vacuum deposited on the EBL with a thickness of 20 nm.

Then, a hole-blocking layer (HBL) was formed on the EML with a thickness of 10 nm by depositing 4,7-Diphenyl-1,10-phenanthroline (BPhen). The electron transport layer (ETL) was vacuum deposited on the HBL by co-evaporation of 4,7-Diphenyl-1,10-phenanthroline (BPhen) and Cs with a ratio of 1:1 and a thickness of 25 nm. Then, 100 nm of Al was deposited on the ETL to form a cathode layer.

The OLED structure was protected from ambient conditions by encapsulation glass lid that forms a cavity. This cavity contains a getter material, further ensuring the integrity and longevity of the OLED structure.

The OLED structure of Comparative Example 1 (CE1) was prepared in the same way as Example 1, but the hole-injection layer does not contain a p-dopant.

The OLED structure of Comparative Example 2 (CE2) was prepared in the same way as Example 1, but instead of C3 3 vol% of the well-known p-dopant 1,3,4,5,7,8-hexafluorotetracyanonaphthoquinodimethane (F6-TCNNQ) was used as a p-dopant in the hole-injection layer.

The electro-optical performance parameters of the OLEDs were measured at room temperature. The current-voltage characteristic is measured using source-measure unit Keithley 2400. The voltage is applied with the step of 0.1 V in the range from -2 V to 6 V. Current through the OLED device is detected at each voltage step. The light intensity is measured by the spectrometer CAS 140 CT. Additionally, the OLED light intensity is detected by the photodiode at each voltage step, the signal of which is sensed by another source-measure unit Keithley 2400. The device lifetime was evaluated by monitoring the luminance decay over time. OLEDs were placed in black boxes and operated at a constant current density of 10 mA/cm². Luminance was measured using a photodiode at 600-second intervals. The LT70 value was determined as the time at which the luminance decreased to 70% of its initial value. Simultaneously, the operating voltage was recorded, and the voltage at LT70 was noted. ΔV (LT70)/V0 describes the relative change in voltage with respect to the initial voltage.

**Table 2**

| | p-Dopant | Dopant concentrati on (vol%) | Voltage [V] at 10 mA/cm² | Current efficiency [cd/A] at 10 mA/ cm² | LT70 at 10 mA/ cm² | ΔV (LT70)/V0 (%) |
|---|---|---|---|---|---|---|
| CE1 | none | 0 | 5.85 | 9.43 | 1 | 31 |
| CE2 | F6-TCNNQ | 4 | 4.11 | 11.5 | 68 | 45 |
| E1 | C3 | 4 | 3.86 | 11.5 | 66 | 12 |

Table 2 shows the technical effect. The OLED structure of example 1 (E1) has a significantly reduced driving voltage and much better voltage stability as reflected in a lower voltage rise ΔV (LT70)/V0 than OLED structures of comparative examples CE1 and CE2, wherein CE2 is an OLED structure with F6-TCNNQ as a p-dopant. In comparison to an OLED structure without p-dopant in the hole-injection layer, the lifetime is also much longer.

This advantageously results in lower power consumption, which is particularly relevant for battery-operated mobile applications, and improved device operating lifetime.

In summary, the inventive examples show high evaporation temperatures suitable for mass production and lead to conductivities of semiconductor matrix materials that allow for application in organic electronic devices.

### DESCRIPTION OF THE DRAWING

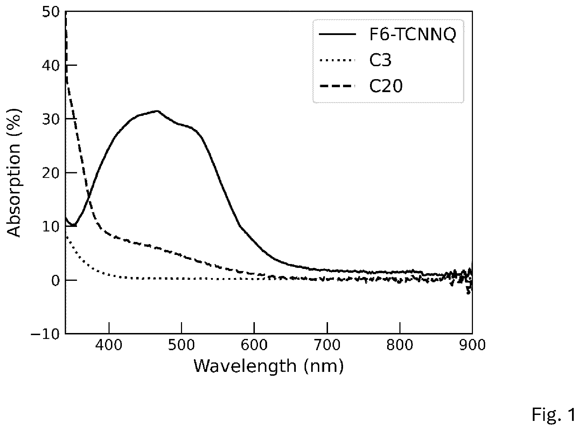

- FIG. 1: shows two absorption spectra of two of the Examples.

Another technical effect is shown in Fig. 1, where absorption spectra of the inventive examples C3 and C20, as well as of the reference F6-TCNNQ are plotted over the wavelength. It is shown that the inventive examples C3 and C20 show significant less absorption in the region between 340 nm and 600 nm, i.e. the absorption in the UV to visible range is lower in comparison to F6-TCNNQ. This is advantageous for the improvement of efficiency in organic electronic devices, such as OLEDs.

## Claims

1. **An electronic component** comprising at least one compound according to formula (I)
[Ce⁴⁺] L_{A}²⁻L_{B}²⁻ (I),
wherein L_{A}, L_{B} are independently of each other a tetradentate ligand with at least 26 carbon atoms,
wherein L_{A}, L_{B} are each coordinating with at least four oxygen atoms to Ce⁴⁺,
wherein L_{A}, L_{B} have the same or different meanings.

2. The electronic component according to claim 1, wherein
L_{A}, L_{B} are each tetradentate ligands independently selected from formula (II) 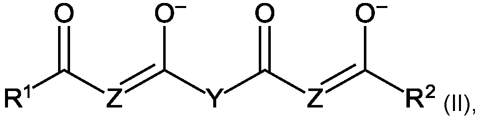
wherein Z is the same or different at each instance selected from C-H, C-D, C-CF₃ and C-R³;
wherein R¹, R², and R³ independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl, C₃-C₆-cyclohaloalkyl or C₁-C₆-haloalkyl,
wherein aryl and heteroaryl are unsubstituted or substituted by 1, 2, 3, 4 or 5 identical or different radicals R⁴;
wherein R⁴ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
Y is selected from the formula (III.a) to (III.g) 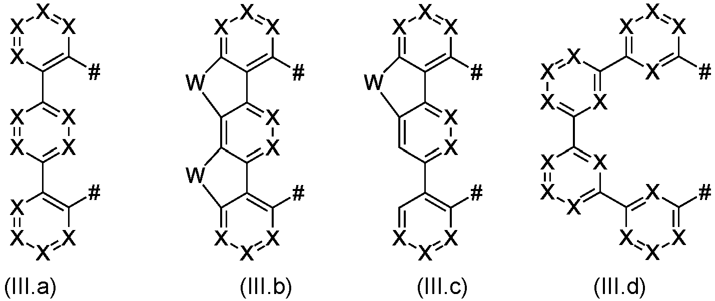 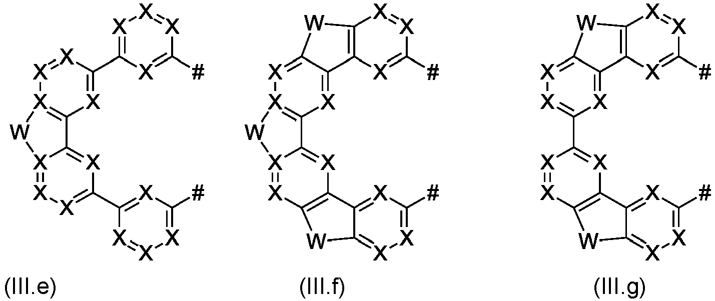
wherein # denotes the bond to the remaining molecule of formula (II),
wherein
X is the same or different at each instance selected from C-H, C-CF₃ and C-R⁵;
wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl,
wherein W is the same or different at each instance and is S, O, -CO-, -SO₂-, CR⁶=CR⁶-, -C(R⁶)2-C(R⁶)2-, -C(R⁶)₂-, -POR⁷-
wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl,
wherein R⁷ is selected from C₆-C₁₂-aryl or C₄-C₁₀-heteroaryl, which is unsubstituted or substituted by 1, 2 or 3 identical or different radicals selected from F, CN, C₁-C₄-alkyl and C₁-C₄-haloalkyl.

3. The electronic component according to claim 2, wherein Z is C-H.

4. The electronic component according to claim 2 or 3, wherein Y is selected from the formulas (III.a) and (Ill.d).

5. The electronic component according to any one of the claims 2 to 4, wherein each of R¹ and R² can be independently selected from CF₃, C₂F₅, n-C₃F₇, n-C₄F₉ and Y is selected from one of the formulas (III.1) - (III.50): 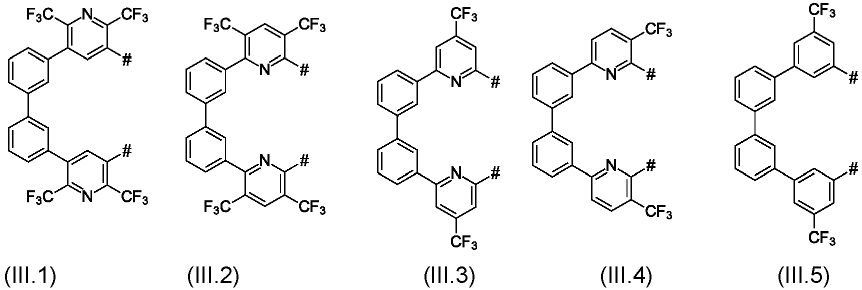 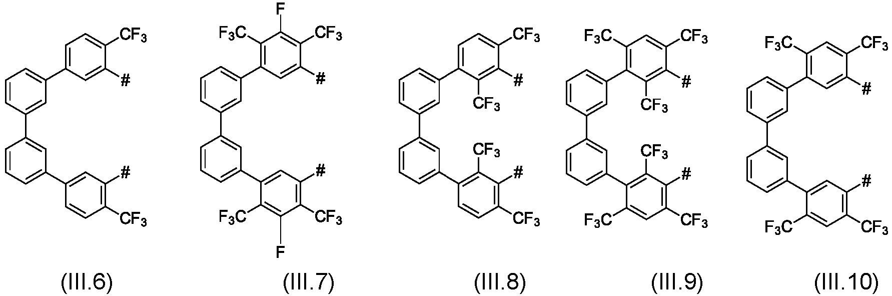 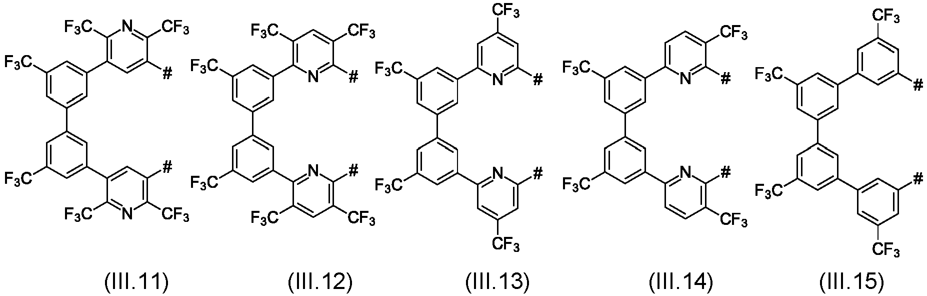 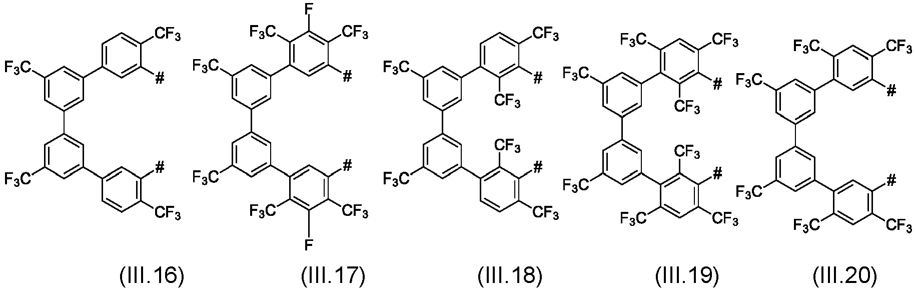 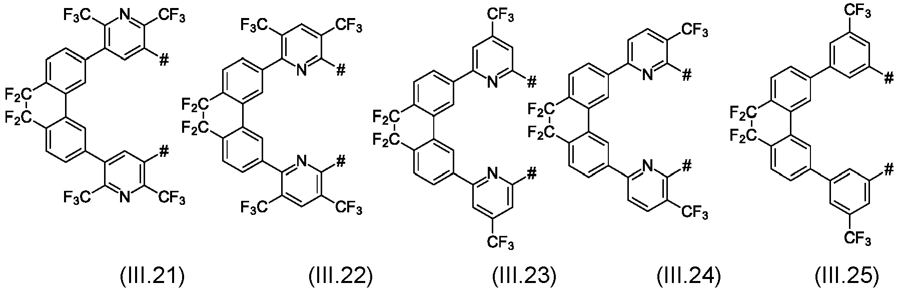 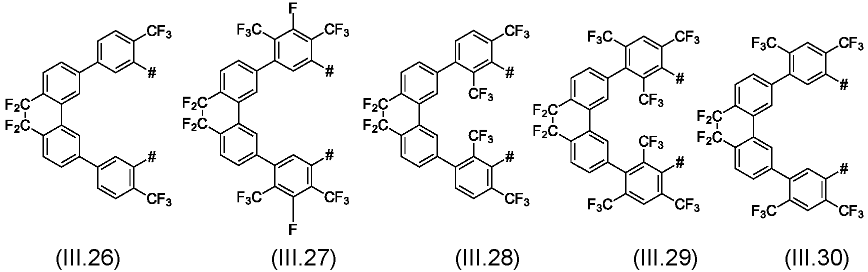 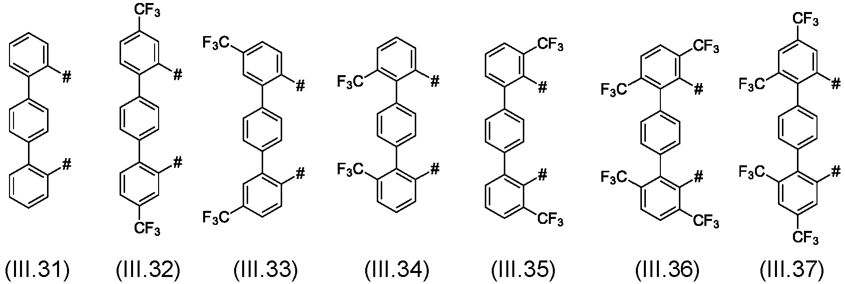 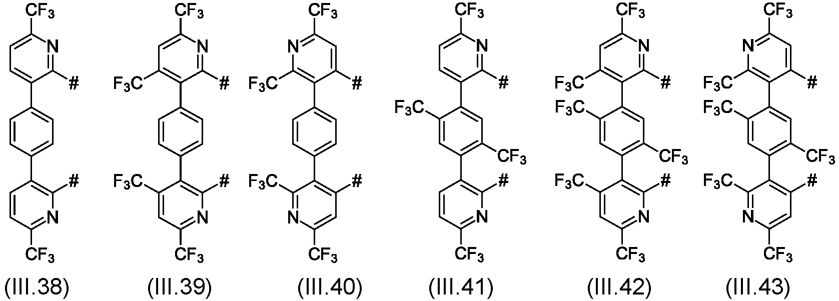 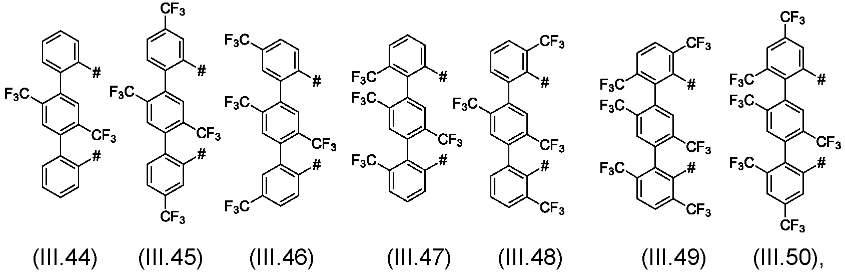
wherein # denotes the bond to the remaining molecule of formula (II), preferably
wherein Y is selected from one of the formulas (III.7), (III.15), (III.17), and (III.25).

6. The electronic component according to any one of the claims 2 to 5, wherein R¹ and R² are the same, in particular selected from CF₃, C₂F₅, and n-C₃F₇,

7. The electronic component according to any one of the claims 1 to 6, wherein L_{A}, L_{B} in formula (I) have the same meaning.

8. The electronic component according to any one of the claims 1 to 7 in form of
- a light-emitting device, preferably a light-emitting diode,
- a display device,
- a photovoltaic cell,
- an organic photodetector,
- an organic transistor,
- an organic diode,
- an organic laser diode,
- an organic or hybrid solar cell,
- an organic transistor, preferably an organic vertical transistor, or
- a battery.

9. The electronic component according to any one of the claims 1 to 8, comprising at least one p-type semiconductor layer, which is a hole transport layer and/or a hole injection layer and/or a hole extraction layer and/or a p-type charge generation layer, which comprise at least one or more of the compounds of formula (I).

10. A compound of formula (I)
[Ce⁴⁺] L_{A}²⁻L_{B}²⁻ (I),
wherein L_{A}, L_{B} are independently of each other a tetradentate ligand with at least 26 carbon atoms,
wherein L_{A}, L_{B} are coordinating with at least four Oxygen atoms to Ce⁴⁺, wherein L_{A}, L_{B} have the same or different meanings.

11. The compound according to claim 10, wherein
L_{A}, L_{B} are each tetradentate ligands independently selected from formula (II) 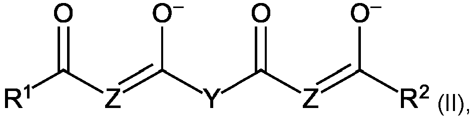
wherein Z is the same or different at each instance selected from C-H, C-D, C-CF₃ and C-R³;
wherein R¹, R², and R³ independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₃-C₆-cycloalkyl, C₃-C₆-cyclohaloalkyl or C₁-C₆-haloalkyl,
wherein aryl and heteroaryl are unsubstituted or substituted by 1, 2, 3, 4 or 5 identical or different radicals R⁴;
wherein R⁴ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
Y is selected from the formula (III.a) to (III.g) 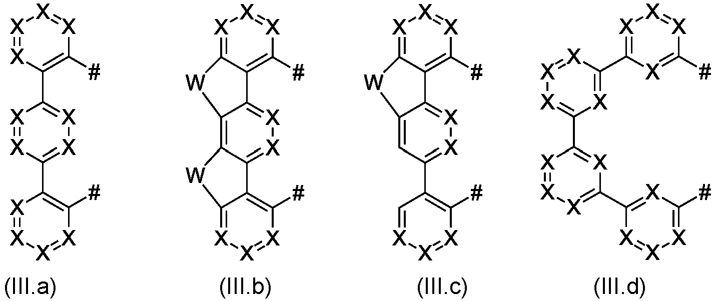 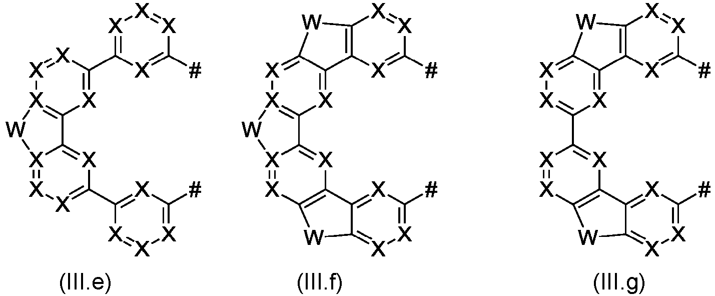
wherein # denotes the bond to the remaining molecule of formula (II),
wherein
X is the same or different at each instance selected from C-H, C-CF₃ and C-R⁵;
wherein R³ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.
W is the same or different at each instance and is S, O, -CO-, -SO2-, -CR⁶=CR⁶-, -C(R⁶)2-C(R⁶)2-, -C(R⁶)₂-, -POR⁷- ,
wherein R⁶ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl,
wherein R⁷ is selected from C₆-C₁₂-aryl or C₄-C₁₀-heteroaryl, which is unsubstituted or substituted by 1, 2 or 3 identical or different radicals selected from F, CN, C₁-C₄-alkyl and C₁-C₄-haloalkyl.

12. The compound according to claim 11, wherein Z is C-H and wherein Y is selected from the formulas (III.a) and (III.d).

13. A doped semiconductor layer comprising at least one electron donor and at least one doping agent, wherein the doping agent is a compound of the formula (I) as defined in any one of the claims 1 to 12.

14. A use of the compound of formula (I) according to claim 10 or 11 as semiconductor,
- as a redox doping agent in semiconductor layers,
- as p-dopant in hole transport layers,
- as charge injector in a charge injection layer,
- as charge extractor in a charge extraction layer,
- as a sublayer of a pn-junction, especially as a sublayer of a charge-generation layer or a charge conversion layer
- as acceptor compound in charge-transfer complexes,
- as cathode material in organic and redox flow batteries,
- as electrochromic material.

15. A method for the preparation of a doped semiconductor layer, wherein a hole transport material and a compound of general formula (I) according to one of the claims 1 to 12 is used, comprising at least one of the following steps:
(a) Simultaneous evaporation of the hole transport material and the compound of formula (I),
(b) Evaporation of a pre-mixed material containing the hole transport material and at least one compound of general formula (I) from one single source,
(c) Sequential deposition of the hole transport material and at least one compound of general formula (I),
(d) Doping of a hole transport layer by a solution containing at least one compound of general formula (I)followed by evaporation of the solvent by thermal treatment,
(e) Surface doping of a layer of a hole transport material by a layer of at least one compound of general formula (I) applied to one or both surfaces of the layer of a hole transport material,
(f) Preparing a solution of a hole transport material and at least one compound of general formula (I) and forming a film from the solution.
